(19) Europäisches Patentamt / European Patent Office / Office européen des brevets

(11) **EP 4 764 574 A1**

(12) **EUROPEAN PATENT APPLICATION**

(43) Date of publication:
**24.06.2026 Bulletin 2026/26**

(21) Application number: **24220975.7**

(22) Date of filing: **18.12.2024**

(51) International Patent Classification (IPC):
**G01R 33/00** (2006.01)    **G01R 33/022** (2006.01)
**G01R 33/07** (2006.01)

(52) Cooperative Patent Classification (CPC):
**G01R 33/022; G01R 33/0029; G01R 33/0082; G01R 33/07**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Melexis Technologies SA**
**2022 Bevaix (CH)**

(72) Inventor: **CHABLOZ, Jérémie**
**2022 Bevaix (CH)**

(74) Representative: **Jacobs, Lambert**
**Inventrans BV**
**Overwegstraat 24**
**3740 Bilzen (BE)**

(54)    **DEVICES AND METHODS FOR MEASURING A MAGNETIC FIELD GRADIENT**

(57)    Method (500) of determining a gradient (G1) of a magnetic field generated by a magnetic source, comprising the steps of: a) providing a first sensor signal (s1) by a first magnetic sensor located at a first sensor location (p1); b) providing a second sensor signal (s2) by a second magnetic sensor located at a second sensor location (p2) located at a second sensor location (p2); c) determining a difference (DIFF12) between the first and the second sensor signal (s1,s2); d) determining said gradient (G1) as a value proportional to a combination of said difference (DIFF12) and a correction term (CORR12) being a predefined function of the first and the second signal (s1, s2), e.g. as G1=(s1-s2)+w*(s1+s2). A device or system configured for performing this method.

$Bz1 = h1$
$Bz2 = h2$

if magnetic sensitivity S1 = magnetic sensitivity S2,
then gradient $dBzdx = (h2-h1)$

if magnetic sensitivity S1 ≠ magnetic sensitivity S2,
    gradient $dBzdx = (h2-h1) + f1(h1,h2)$
e.g. gradient $dBzdx = (h2-h1) + w*(h2+h1)$
e.g. gradient $dBzdx = (h2-h1) + w(T)*(h2+h1)$
e.g. gradient $dBzdx = (h2-h1) + w(T1)*h1 + w(T2)*h2$

**FIG. 1(a)**

**Description**

**Field of the invention**

The present invention relates in general to the field of magnetic sensor devices and methods of measuring a magnetic field, and more in particular to devices and methods of measuring a magnetic field gradient, a linear or angular position, an electrical current, a mechanical stress or torque.

**Background of the invention**

Devices for measuring a magnetic field strength are known in the art. They often contain one or more Hall elements or magneto resistive (MR) elements. Magnetic sensors are typically used in current sensors, distance sensors, proximity sensors, proximity switches, linear or angular position sensors, etc. While magnetic sensing offers several advantages, such as non-contact measurement, less mechanical wear, accuracy of these devices is limited in the presence of an external disturbance field.

In recent years, it was found that the influence of an external disturbance field can be largely reduced by measuring a magnetic field gradient, and by calculating the current or distance or position from the magnetic field gradient signal, rather than from the magnetic field component value itself. It is a challenge to determine a magnetic field gradient even more accurate in view of residual errors caused by external disturbance fields, such as described in EP3885779A1, wherein one of the magnetic sensor signals is adjusted before to calculate the signals' gradient.

There is always room for improvements or alternatives.

**Summary of the invention**

It is an object of the present invention to provide a magnetic sensor device and/or a method for measuring a gradient of a magnetic field.

It is a particular object of embodiments of the present invention to provide a magnetic sensor device and/or a method capable of measuring a gradient of a magnetic field more accurately.

It is an object of embodiments of the present invention to provide a magnetic sensor device and/or a method for measuring a gradient using simpler hardware and/or using a simpler manufacturing process, e.g. without laser trimming, without using an adjustable biasing source, without using an adjustable amplifier gain, and preferably all of these.

It is an object of embodiments of the present invention to provide a magnetic sensor device and/or a method for measuring a gradient of a magnetic field more accurately, despite temperature variations and/or stress variations over the sensor device, in a simple manner.

It is an object of embodiments of the present invention to provide a magnetic sensor device and/or a method for measuring a gradient of a magnetic field more accurately, without having to solve a set of equations.

It is also an object of embodiments of the present invention to provide a current sensor device and/or a method of measuring a current based on a magnetic field gradient.

It is also an object of embodiments of the present invention to provide a position sensor device e.g. capable of determining a linear or an angular position of a magnetic source based on magnetic field gradients.

It is also an object of embodiments of the present invention to provide a current sensor device, e.g. capable of determining an electrical current passing through a conductor based on a magnetic field gradient.

It is also an object of embodiments of the present invention to provide a magnetoelastic sensor device, e.g. capable of determining a mechanical stress applied on a magnetizable material (e.g. ferromagnetic material) based on a magnetic field gradient.

According to a first aspect, the present invention provides a magnetic sensor device for measuring a gradient (e.g. G1) of a magnetic field generated by a magnetic source, comprising: a first magnetic sensor located on a first sensor location, and configured for providing a first sensor signal or a first set of sensor signals; a second magnetic sensor located on a second sensor location, spaced from the first sensor location, and configured for providing a second sensor signal or a second set of sensor signals; a processing circuit for determining a gradient based on the first and second sensor signal, or based on the first and second set of sensor signals; wherein the processing circuit is configured for determining a difference (e.g. DIFF12) between the first and the second sensor signal, or for determining a difference between a first combined signal derived from the first set of sensor signals and a second combined signal derived from the second set of sensor signals; and the processing circuit is configured for determining a correction term (e.g. CORR12) as a predefined function of the first and second sensor signal or as a predefined function of the first and second set of sensor signals; and the processing circuit is configured for determining said gradient (e.g. G1) as a value proportional to a combination (e.g. a sum or a difference) of said difference (e.g. DIFF12) and said correction term (e.g. CORR12), e.g. in accordance with the following formulas: DIFF12=(s1-s2); CORR12=f(s1,s2); G1=DIFF12+CORR12.

With " predefined function " is meant a function having a predefined sequence of one or more mathematical operations and having predefined coefficients (e.g. multiplicative factors , constants, polynomial coefficients, scaling factors) acting on one or more variables, and wherein one or more sensor signals are variable of the function.

It is an advantage of the present invention that an accurate value of a magnetic field gradient can be determined using a first and a second magnetic sensor which are not exactly matched to each other, e.g. by laser-trimming and/or by using an adjustable biasing source. Thus, a magnetic sensor device according to the present invention is easier to produce (no laser-trimming required), and/or is less complex to design and/or to operate (no adjustable biasing signal required).

It is a major advantage of the present invention that the gradient thus determined has a reduced sensitivity to (i.e. is highly independent of) an magnetic disturbance field.

The magnetic sensor device may be a packaged semiconductor device ("a single chip"), or may be a printed circuit board comprising a processor (e.g. an MCU or an ECU) and said first and second magnetic sensor.

Surprisingly, the inventors found an accurate gradient determination technique that is based on removing sensitivity mismatch induced errors in the (raw) differential signal (i.e. representing a difference of the signals) by a simple post-processing involving a sequence of few mathematical operations with predefined coefficients, in contrast to opinions that allege a difficulty to remove such errors from the differential signal in an easy way.

It is noted that "the processing circuit" may be a digital processing circuit inside the sensor device, or a digital processing circuit inside an external device, or both, advantageously "the processing circuit" may comprise one or more analog-to-digital converters (ADCs) for digitizing one or more signals. Alternatively or complementarily, "the processing circuit" can either be constituted by, or can comprise, one or more analog processing circuit(s).

Preferably the correction term is different from zero, hence the gradient is determined as a combination of said different and said non-zero correction term.

In an embodiment, the predefined function is a polynomial expression of the first and second sensor signal ($s1$, $s2$), or is a polynomial expression of the first and second set of sensor signals, e.g.: $c0 + c1*s1 + c2*s2 + c3*s1^2 + c4*s2^2 + c5*s1^3 + c6*s2^3$, wherein at least a plurality up to all coefficients $c0$-$c6$ are different from $0.0$ (i.e. non-zero coefficients, not zero constants).

In an embodiment, the predefined function is a linear combination (i.e. a polynomial expression of $1^{st}$ degree, also called "linear polynomial") of the first and second sensor signal ($s1$, $s2$), or is a linear combination of the first and second set of sensor signals, with or without a constant, e.g.: $c0 + c1*s1 + c2*s2$, wherein at least one of $c1$ and $c2$, but preferably both of the coefficients $c1$ and $c2$ are different from $0.0$ (i.e. non-zero coefficients, not zero constants).

In an embodiment, the predefined function is a scaled sum of the first and second sensor signal, or is a scaled sum of the first and second set of sensor signals (i.e. a reformulation of a polynomial expression of 1st degree where the coefficients of both signals are identical), with or without a constant, e.g.: $c*(s1 + s2)$, wherein the coefficient $c$ is different from $0.0$ (i.e. a non-zero coefficient, not a zero constant).

The coefficients of the polynomial expression or of the linear combination may be predefined constants, or may be temperature dependent values, which can be determined during a calibration procedure. Preferably at least one of the coefficients is different from zero.

With a "linear combination of signal $s1$ and signal $s2$" is meant for example: $c1*s1 + c2*s2$, wherein at least one, but preferably both of the coefficients $c1$ and $c2$ is different from $0.0$.

With "scaled sum of the signals $s1$ and $s2$" is meant for example $c1*(s1+s2)$, wherein the scaling factor $c1$ is different from $0.0$ (i.e. a non-zero coefficient, not a zero constant).

In an embodiment, the magnetic sensor can further comprise a common mode magnetic sensor having one or more magnetic sensing element(s) and providing a common mode sensor signal in view of substitute the first and the second sensor signal as variable in said predefined function. The common mode magnetic sensor is thus located on a predefined location with respect to said first and second location, and configured so as the common mode sensor signal can approximate up to substantially correspond to a combination of the first and the second sensor signal being a variable of the predefined function, notably a linear combination of the first and second sensor signal on which a coefficient can be - for example- directly applied for determining the correction term. In a preferred embodiment, the common mode magnetic sensor is substantially located in the middle between the first and the second sensor so as to sense a magnetic field component that substantially corresponds to a sum of the first and second sensor signal. In a similar embodiment, the common mode magnetic sensor can be configured to providing a common mode set of sensor signals for substitute the first and second set of sensor signals in the predefined function. In these embodiments, the processing circuit can thus be configured for determining said correction term based on said common mode sensor signal or a common mode set of sensor signals, e.g. by applying predefined function's coefficients.

The one or more coefficient(s) can be determined during a calibration procedure, preferably on a chip-by-chip level, and may be stored in a non-volatile memory, e.g. in a non-volatile memory of the sensor device, or in another non-volatile memory, e.g. a non-volatile memory external of the sensor device, but connected thereto, or a non-volatile memory of an MCU or of an ECU communicatively connected to the sensor device). The one or more coefficient(s) may be predefined constant(s) or may be temperature dependent.

In an embodiment, the predefined function is a "scaled sum" of the first and second signal, e.g. in accordance with the formula CORR12=w1*(s1+s2), and the coefficient w1 is determined during a calibration, by applying a constant magnetic field (i.e. a field with constant magnitude at the first and second sensor location), measuring the two signals s1, s2, subtracting them, which should be zero because the gradient of a constant field is zero, but if the sensitivities are not identical, the difference (s1-s2) will not be exactly zero, but will be a small value. The coefficient w1 is then chosen such that (s1-s2)+w1*(s1+s2)=0, by setting w1 equal to (s2-s1)/(s1+s2) when applying a constant magnetic field.

In preferred embodiments, the first magnetic sensor and the second magnetic sensor are biased using a predefined current source or a predefined voltage-source, as opposed to an adjustable biasing source. In an embodiment, a single biasing source (e.g. a single current source or a single voltage source) is used to bias the first magnetic sensor and the second magnetic sensor. In another embodiment, the first biasing source is a predefined current source, and the second biasing source is a current mirror of the first biasing source. It is an advantage of the present invention that the sensitivity correction is performed mainly in the digital domain. This simplifies the implementation, (inter alia) because a digitally trimmable or adjustable biasing source is not required, and less routing is required.

The first magnetic sensor may be located at a first sensor location, and the second magnetic sensor may be located at a second sensor location spaced from the first sensor location by a distance (e.g. dx), e.g. a distance in the range from 0.5 mm to 15.0 mm, or in the range from 0.8 mm to 12.0 mm. In certain embodiments, the distance dx is a value in the range from 0.8 mm to 2.5 mm.

In an embodiment, the magnetic sensor device further comprises at least one amplifier for amplifying one or more of the following signals: the first sensor signal (s1), the second sensor signal (s2), an analog difference between the first and second sensor signal (i.e. "s1-s2"), an analog sum of the first and second sensor signal (i.e. "s1+s2").

In an embodiment, the magnetic sensor device further comprises at least one analog-to-digital converter (ADC) for digitizing one or more of the following signals: the first sensor signal (s1) or an amplified version thereof, the second sensor signal (s2) or an amplified version thereof, an analog difference between the first and second sensor signal (i.e. "s1-s2") or an amplified version thereof, an analog sum of the first and second sensor signal (i.e. "s1+s2") or an amplified version thereof.

In an embodiment, the processing circuit is a digital processing circuit connected downstream of the at least one analog-to-digital convertor (ADC) configured to process the data provided by the at least one ADC in the digital domain.

In an embodiment, the first magnetic sensor has a first magnetic sensitivity (S1), and the second magnetic sensor has a second magnetic sensitivity (S2) different from the first magnetic sensitivity (51).

It is noted that the first and second sensitivity S1, S2 may not be purposely different, but in practice they are almost always involuntarily slightly different because of manufacturing tolerances, e.g. resulting in Hall-plate variations.

In an embodiment, the first magnetic sensor has a first set of magnetic sensitivities, and the second magnetic sensor has a second set of magnetic sensitivities different from the first set of magnetic sensitivities.

In an embodiment, the first magnetic sensor has at least one first magnetic sensor element with a first magnetic sensitivity, and the second magnetic sensor has at least one second magnetic sensor element with a second magnetic sensitivity different from the first magnetic sensitivity, e.g. at least 4.0 % different, or at least 3.0 % different, or at least 2.0 % different, or at least 1.0 % different, the first and the second sensitivity being typically in a range from 50 to 200 mV/Tesla at 35°C.

In an embodiment, the first magnetic sensor has at least one first magnetic sensor element with a first magnetic sensitivity, and the second magnetic sensor has at least one second magnetic sensor element with a second magnetic sensitivity, and the second magnetic sensor element is not trimmed (e.g. laser-trimmed) to match the second magnetic sensitivity to the first magnetic sensitivity.

In an embodiment, the correction term (e.g. CORR12) is determined in accordance with the following formula: CORR12=w1*(s1+s2), wherein coefficient w1 is a scaling factor different from zero.

In an embodiment, the correction term (e.g. CORR12) is determined in accordance with the following formula: CORR12=(w1*s1)+(w2*s2), wherein coefficient w1 is a first scaling factor different from zero, and coefficient w2 is a second scaling factor different from zero.

In preferred embodiments, the absolute values of coefficient w1 and w2 are values in the range from 0.001 to 0.100, or from 0.001 to 0.050, or in the range from 0.002 to 0.100, or in the range from 0.002 to 0.050, or in the range from 0.005 to 0.100, or in the range from 0.005 to 0.050

In an embodiment, the magnetic sensor device further comprises a non-volatile memory storing (predefined coefficients of) said predefined function, e.g. by storing coefficients of a polynomial expression, or by storing one or more scaling factors, or in any other suitable way (e.g. as a look-up table).

The non-volatile memory may be part of the sensor device itself, or may be external from said sensor device, e.g. as a discrete chip on a PCB, or as part of an external processor (e.g. an MCU or ECU) communicatively connected to the magnetic sensor.

The magnetic sensor device may be a packaged semiconductor device (also known as "a chip").

The magnetic sensor device may comprise a lead frame.

The magnetic sensor device may be a wafer-level-packaged (WLP) device comprising at least two or least three semiconductor substrates, spaced apart from each other, and connected to each other using at least one RDL-layer.

In an embodiment, the magnetic sensor device further comprises at least one temperature sensor for measuring at least one temperature, and the processing circuit is further configured for determining said gradient by taking into account the measured temperature. In fact, the inventors noticed that the use of coefficient(s) being function of the temperature(s) of the first and/or the second magnetic sensor allows a better attenuation of the residual errors in the corrected gradient as sensitivity mismatch induced errors seem to be sensitive to temperature changes. The magnetic sensor can thus comprise an analog-to-digital converter for digitizing at least one temperature signal provided by said at least one temperature sensor.

In an embodiment, the magnetic sensor device further comprises a protective casing housing at least said first magnetic sensor, said second magnetic sensor and said processing circuit. Optionally the protective casing also houses one or more of said non-volatile memory, and said at least one temperature sensor.

In an embodiment, the magnetic sensor device further comprises a semiconductor substrate comprising said first magnetic sensor and said second magnetic sensor and a temperature sensor for measuring a temperature of the semiconductor substrate; (e.g. located between the first and second magnetic sensor on the semiconductor substrate, e.g. located such that a ratio of a first distance d1 between the temperature sensor and the first magnetic sensor, and a second distance d2 between the temperature sensor and the second magnetic sensor is a value in the range from 50% to 200%); and the processing circuit is configured for determining the correction term (e.g. CORR12) in accordance with the following formula: CORR12=w(T)*(s1 + s2), wherein w(T) is a scaling function of temperature (i.e. a coefficient whose value is predetermined based on a measured temperature, e.g. of the magnetic sensor), different from zero.

Using a single temperature sensor makes the calculation relatively easy, and may be particularly useful if the two magnetic sensors and the temperature sensor are embedded in a single semiconductor substrate.

In an embodiment, the magnetic sensor device further comprises a first temperature sensor for measuring a first temperature (e.g. T1) of the first magnetic sensor; and further comprising a second temperature sensor for measuring a second temperature (e.g. T2) of the second magnetic sensor; and the processing circuit is configured for determining the correction term (e.g. CORR12) in accordance with the following formula: CORR12=w(T1)*s1 + w(T2)*s2, wherein w(.) is a first scaling function of temperature, different from zero, T1 is the first temperature, and T2 is the second temperature.

Using two temperature sensors may be particularly useful if the two magnetic sensors are embedded in two separate semiconductor substrates, e.g. a first sensor substrate and a second sensor substrate, e.g. as part of a WLP-package. Preferably the first sensor substrate also comprises the first temperature sensor, and the second sensor substrate also comprises the second temperature sensor.

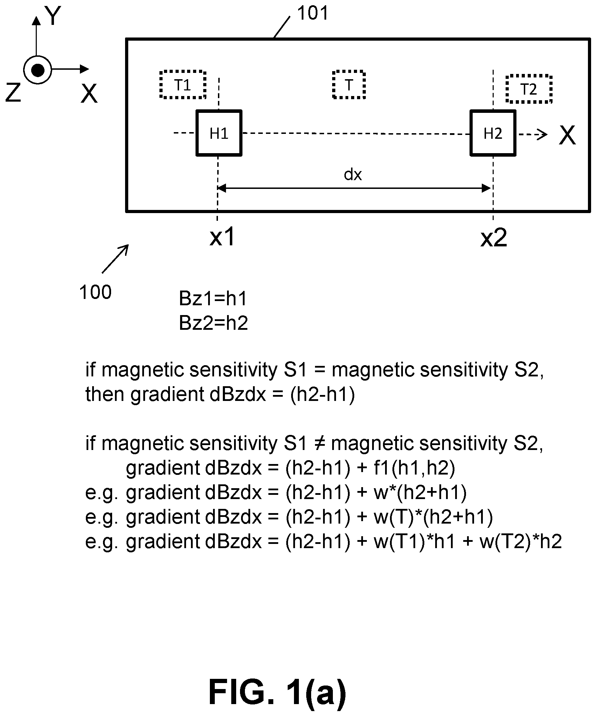

In an embodiment, the first magnetic sensor is or comprises a first horizontal Hall element, and the second magnetic sensor is or comprises a second horizontal Hall element. Examples of this embodiment are illustrated in FIG. 1(a) and FIG. 4(b) and FIG. 7(a) and FIG. 8(a).

In an embodiment, each of the first and second magnetic sensor comprises two horizontal Hall elements. They may be arranged relatively close to each other, e.g. at a distance of at most 100 micron, or at most 75 micron. They may for example be connected in parallel, or connected in series.

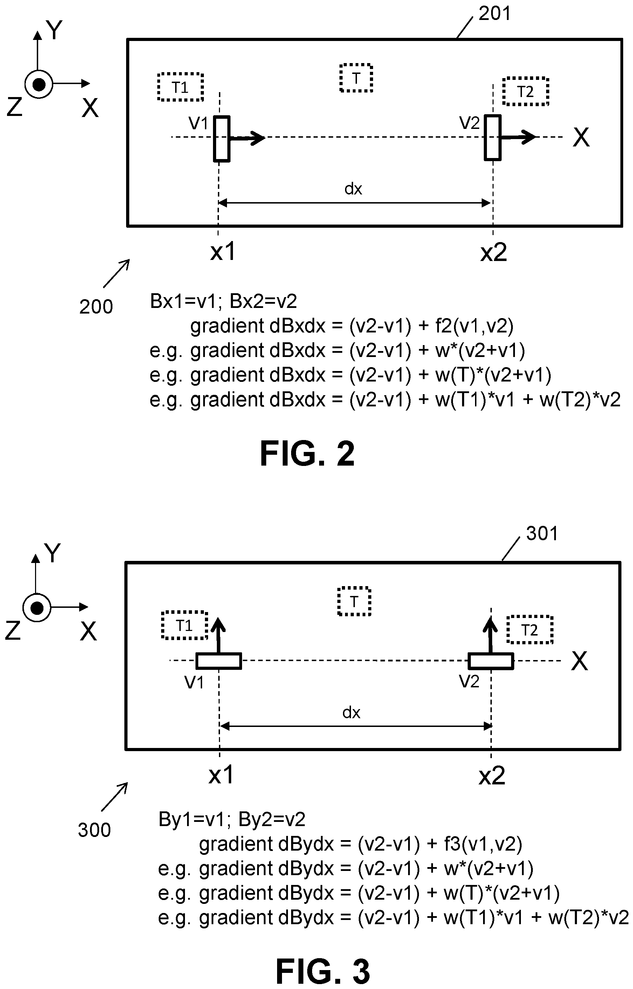

In an embodiment, the first magnetic sensor is or comprises a first vertical Hall element, and the second magnetic sensor is or comprises a second vertical Hall element. Examples of this embodiment are illustrated in FIG. 2 and FIG. 3.

In an embodiment, each of the first and second magnetic sensor comprises two vertical Hall elements. They may be arranged relatively close to each other, e.g. at a distance of at most 150 micron, or at most 100 micron, or at most 75 micron. They may for example be connected in parallel, or connected in series.

In an embodiment, each of the first and second magnetic sensor comprises a horizontal Hall element and one or more vertical Hall elements, e.g. a horizontal Hall element and one or two vertical Hall elements arranged to form a 2D magnetic pixel, or e.g. a horizontal Hall element and two or four vertical Hall elements arranged to form a 3D magnetic pixel.

In an embodiment, the first magnetic sensor comprises a first integrated magnetic concentrator disk (e.g. IMC1) and two horizontal Hall elements (e.g. H1, H2) arranged near a periphery of the first integrated magnetic concentrator disk, and the second magnetic sensor comprises a second integrated magnetic concentrator disk (e.g. IMC2) and two horizontal Hall elements (e.g. H3, H4) arranged near a periphery of the second integrated magnetic concentrator disk.

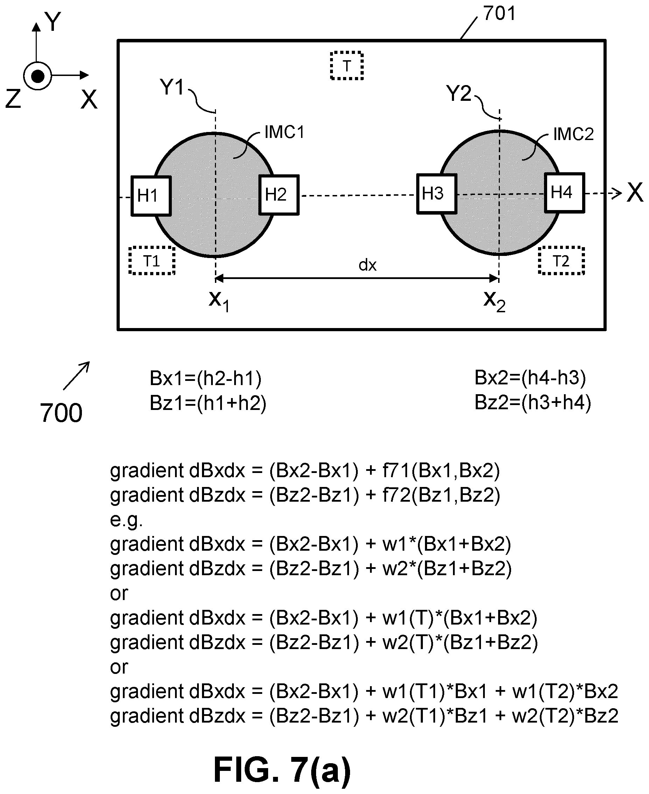

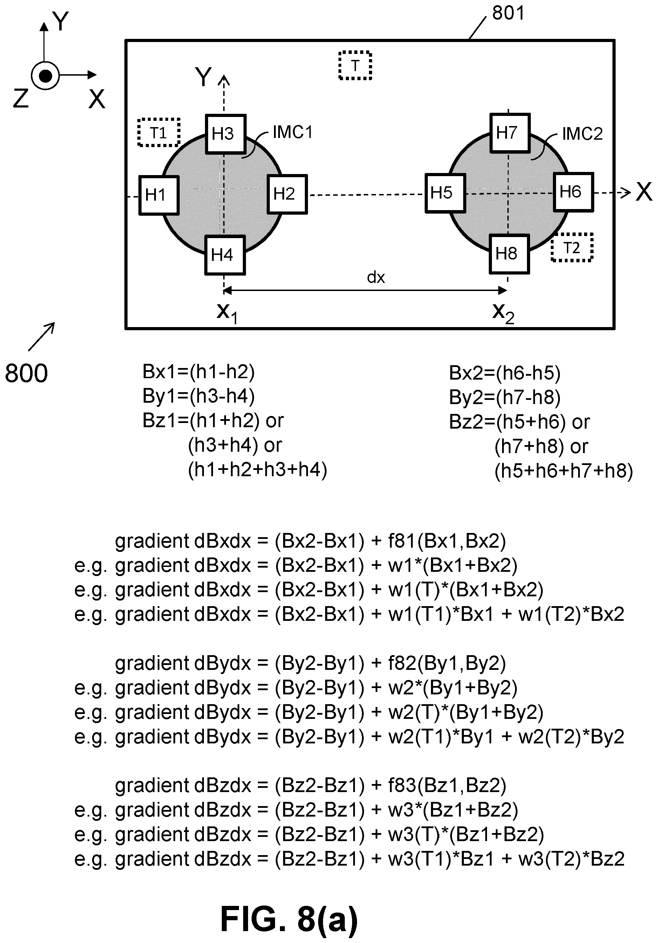

Examples of this embodiment are illustrated in FIG. 7(a) and FIG. 8(a).

In an embodiment, the magnetic sensor device is configured as a current sensor wherein the processing circuit or another processing circuit is configured for determining an electrical current passing through a conductor based on said accurate gradient (G1).

In another embodiment, the magnetic sensor device is configured as a magnetoelastic sensor wherein the processing circuit or another processing circuit is configured for determining a mechanical stress (e.g. torque or a force) applied to a material based on said accurate gradient (G1). In an embodiment, the magnetic sensor device further comprises a third magnetic sensor located at a third sensor location, and configured for providing a third sensor signal (e.g. s3) or a third set of sensor signals; and further comprising a fourth magnetic sensor located at a fourth sensor location spaced from the third sensor location, and configured for providing a fourth sensor signal (e.g. s4) or a fourth set of sensor signals; and wherein the processing circuit is further configured for determining a second difference (e.g. DIFF34) between the third and the fourth sensor signal (e.g. s3, s4); and for determining a second gradient (e.g. G2) as a value proportional to a second combination of said second difference (e.g. DIFF34) and a second correction term (e.g. CORR34) of the third and the fourth sensor signal (e.g. s3, s4), e.g. in accordance with the formula: G2=DIFF34+CORR34.

This sensor device is capable of determining two magnetic field gradients with improved accuracy, e.g. in a manner that is highly insensitive to an external disturbance field.

In an embodiment, the third magnetic sensor has at least one third magnetic sensor element with a third magnetic sensitivity (S3) different from the first and second magnetic sensitivity, and the fourth magnetic sensor has at least one magnetic sensor element with a fourth magnetic sensitivity (S4) different from the first, second and third magnetic sensitivity;

In an embodiment, one or more of the following features are applicable:

wherein the first, second, third and fourth magnetic sensor are horizontal Hall elements;
wherein the first, second, third and fourth magnetic sensor are located on a virtual circle,
wherein the first and second magnetic sensor are located diametrically opposite each other,
wherein the third and fourth magnetic sensor are located diametrically opposite each other,
wherein the first and third magnetic sensor are angularly spaced by 90°.

The first gradient (dBzdx) may be determined as G1=(h1-h2)+f1(h1,h2), e.g. as G1=(h1-h2)+K1(T1)*h1+K2(T2)*h2, or as G1=(h1-h2)+K1(T)*(h1+h2), or as G1=(h1-h2)+K1*(h1+h2), wherein f1 is a first predefined function, h1 is the signal from the first horizontal Hall element, h2 is the signal from the second horizontal Hall element, etc.

The second gradient (dBzdy) may be determined as G2=(h3-h4)+f2(h3,h4), e.g. as G2=(h3-h4)+K3(T3)*h3+K4(T4)*h4, or as G2=(h3-h4)+K3(T)*(h3+h4), or as G2=(h3-h4)+K3*(h3+h4).

The linear or angular position may be determined as f(K5*G1/G2), e.g. as α=atan2(K2*G1,G2), wherein f2 is a second predefined function, K5 is a predefined constant, which may depend on the relative position and/or orientation of the sensor device relative to the magnetic source.

In an embodiment, the first and second magnetic sensor are horizontal Hall elements, located on a predefined axis (X), spaced apart by a predefined distance (dx); and the third and fourth magnetic sensor are vertical Hall elements, located on said axis (X), spaced apart by said predefined distance (dx); and the first and third magnetic sensor are located adjacent each other; (e.g. at a distance of at most 300 um from each other); and the second and fourth magnetic sensor are located adjacent each other.

The first gradient (dBzdx) may be determined as G1=(h1-h2)+f1(h1,h2), e.g. as G1=(h1-h2)+K1(T1)*h1+K2(T2)*h2, or as G1=(h1-h2)+K1(T)*(h1+h2), or as G1=(h1-h2)+K1*(h1+h2), where f1 is a first predefined function, h1 is the signal from the first horizontal Hall element, h2 is the signal from the second horizontal Hall element, etc.

The second gradient (dBxdx) may be determined as G2=(v3-v4)+f2(v3,v4), e.g. as G2=(v3-v4)+K3(T3)*v3+K4(T4)*v4, or as G2=(v3-v4)+K3(T)*(v3+v4), or as G2=(v3-v4)+K3*(v3+v4).

The linear or angular position may be determined as f(K5*G1/G2), e.g. as α=atan2(K2*G1,G2), where K5 is a predefined constant, which may depend on the relative position and/or orientation of the sensor device relative to the magnetic source.

In an embodiment, the processing circuit or another processing circuit is configured for determining a linear or an angular position based on a ratio of the first gradient (e.g. G1) and the second gradient (e.g. G2).

The linear or angular position (e.g. α) may be determined as a function (e.g. an arctangent function) of a ratio of the first and second gradient, e.g. in accordance with the following formula: α = f(K5*G1/G2), wherein K5 is a predefined constant (e.g. dependent on the position of the sensor device relative to the magnet), G1 is the first gradient derived from the first and second magnetic sensor signals, and G2 is the second gradient derived from the third and fourth magnetic sensor signals.

The value of K5 may be determined during a calibration procedure, and may also be stored in said non-volatile memory.

It is an advantage of this sensor device that the position can be determined with improved accuracy, e.g. with an improved robustness against an external disturbance field, without having to match the magnetic sensors.

According to a second aspect, the present invention also provides a method of determining a gradient (e.g. G1) of a magnetic field generated by a magnetic source, the method comprising the steps of: a) providing a first sensor signal (e.g. s1) or a first set of sensor signals by a first magnetic sensor located at a first sensor location; b) providing a second sensor signal (e.g. s2) or a second set of sensor signals by a second magnetic sensor located at a second sensor location located at a second sensor location spaced from the first sensor location (e.g. by a predefined distance dx); d) determining a difference e.g. (DIFF12) between the first and the second sensor signal (e.g. s1, s2) or between a first combined signal derived from the first set of sensor signals and a second combined signal derived from the second set of sensor signals; e) determining a correction term (e.g. CORR12) as a predefined function of the first and the second sensor signal (e.g. s1, s2), or of the first combined signal and the second combined signal; f) determining said gradient (e.g. G1) as a value proportional to a combination (e.g. a sum or difference) of said difference (e.g. DIFF12) and said correction term (e.g. CORR12) of the first and the second signal (e.g. s1, s2).

Step d) may comprise determining said difference using the formula: DIFF12 = (s1-s2).

Step e) may comprise determining said correction term in accordance with one of the formulas: CORR12=f(s1,s2), e.g. CORR12=w*(s1+s2), e.g. CORR12=w(T)*(s1+s2), e.g. CORR12=w(T1)*s1+w(T2)*s2, where w is a scaling factor or function, that can be determined during a calibration procedure

It is noted that step d) may be performed in the analog or digital domain, and also step e) can be performed in the analog and/or digital domain.

Preferably step f) is performed after step e).

Preferably the correction term is different from zero. In case the predefined function is a polynomial expression, this means e.g. at least one of the coefficients is different from zero.

In an embodiment, step a) further comprises that said first magnetic sensor comprises at least a first magnetic sensor element having a first magnetic sensitivity (S1), and step b) further comprises that said second magnetic sensor comprises at least a second magnetic sensor element having a second magnetic sensitivity (S2) different from the first magnetic sensitivity (S1), e.g. at least 4% different, or at least 3%, or at least 2%, or at least 1%.

In an embodiment, the method further comprises step c) of measuring one or more temperatures.

The method may further comprise: amplifying one or more signals, e.g. amplifying the sensor signals, and/or amplifying a difference between the sensor signals, and/or amplifying a sum of the sensor signals.

The method may further comprise: digitizing one or more signals, e.g. digitizing the sensor signals, and/or digitizing the amplified sensor signals, and/or digitizing the amplified difference between the sensor signals, and/or digitizing the amplified sum of the sensor signals.

According to a third aspect, the present invention also provides a method of determining a linear or an angular position of a sensor device relative to a magnetic source, an electrical current passing through a conductor, or a mechanical stress applied on a material. In one embodiment, the method comprises an additional step g) of determining a linear or an angular position of a magnetic source, an electrical current passing through a conductor, or a mechanical stress applied on a material based on the gradient (G1) determined on step f).

Advantageously, the present invention also provides a method of determining a linear or an angular position of a sensor device relative to a magnetic source wherein the sensor device comprises a first, second, third and fourth magnetic sensor, and wherein the magnetic source generates a magnetic field, the method comprising the steps of: a) determining a first gradient (e.g. G1) by applying the method of the second aspect based on sensor signals from the first and second magnetic sensor; b) determining a second gradient (e.g. G2) by applying the method of the second aspect based on sensor signals from the third and the fourth magnetic sensor; c) determining a linear or an angular position based on a ratio of the first gradient (e.g. G1) and the second gradient (e.g. G2).

The first, second, third and fourth magnetic sensor may have four different magnetic sensitivities.

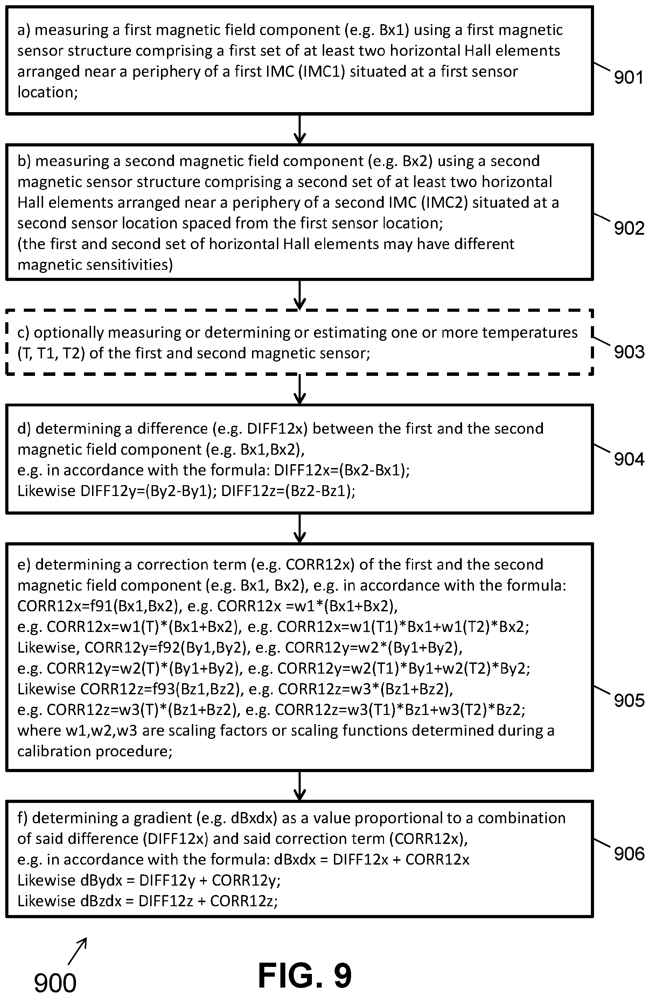

According to a fourth aspect, the present invention also provides a magnetic sensor device for determining a gradient (e.g. G1) of a magnetic field generated by a magnetic source, comprising: a semiconductor substrate comprising a first magnetic sensor structure at a first sensor location, the first magnetic sensor structure comprising a first set of at least two horizontal Hall elements (e.g. H1, H2) located near a periphery of a first integrated magnetic concentrator (e.g. IMC1), and configured for providing a first set of sensor signal (e.g. h1,h2); a processing circuit configured for determining at least a first magnetic field component (e.g. Bx1, By1, Bz1) by combining (e.g. summing or subtracting) signals from the first set of sensor signals (e.g. h1, h2); said semiconductor substrate further comprising a second magnetic sensor structure at a second sensor location, spaced (e.g. dx) from the first sensor location, the second magnetic sensor structure comprising a second set of at least two horizontal Hall elements (e.g. H5, H6) located near a periphery of a second integrated magnetic concentrator (e.g. IMC2), and configured for providing a second set of sensor signal (e.g. h5,h6); said processing circuit being further configured for determining at least a second magnetic field component (e.g. Bx2, By2, Bz2) by combining (e.g. summing or subtracting) signals from the second set of sensor signals (e.g. h5, h6); wherein the processing circuit is configured for determining a difference (e.g. DIFF12x, DIFF12y, DIFF12z) between the first and the second magnetic field component; and wherein the processing circuit is configured for determining a correction term (e.g. CORR12x, CORR12y, CORR12z) of the first and second magnetic field component (e.g. using any of the formulas mentioned in FIG. 9); and wherein the processing circuit is configured for determining said gradient (e.g. dBxdx, dBydx, dBz/dx) as a value proportional to a combination of said difference (e.g. DIFF12x) and said correction term (e.g. CORR12x), e.g. in accordance with the formula: dBxdx = DIFF12x + CORR12x.

The horizontal Hall elements of the first set and of the second set may have different magnetic sensitivities.

In an embodiment, the first and second sensor structure are configured for measuring a first and a second magnetic field component (e.g. Bx1,Bx2) oriented in a first direction (e.g. X), and wherein the processing circuit is configured for determining a first gradient (e.g. G1=dBxdx) of said magnetic field component oriented in said first direction (e.g. X) along a direction defined by the first and the second sensor location; and the first and second sensor structure are further configured for measuring a third and a fourth magnetic field component (e.g. Bz1,Bz2) oriented in a second direction (e.g. Z) perpendicular to the first direction (e.g. X) and wherein the processing circuit is configured for determining a second gradient (e.g. G2=dBzdx) of said magnetic field component (e.g. Bz) oriented in said second direction along the direction defined by the first and the second sensor location; and the processing circuit is further configured for determining a linear or an angular position based on a ratio of the first gradient (e.g. G1=dBxdx) and the second gradient (e.g. G2=dBydx).

The linear or angular position may be determined as f(K5*G1/G2), e.g. as $\alpha$=atan2(K2*G1,G2), where K5 is a predefined constant, which may depend on the relative position and/or orientation of the sensor device relative to the magnetic source. The value of K5 may be a value in the range from 0.33 to 3.0 or in the range from 0.40 to 2.50.

According to a fifth aspect, the present invention also provides a method of measuring a gradient (e.g. dBxdx) of a magnetic field generated by a magnetic source, comprising the steps of: a) measuring a first magnetic field component (e.g. Bx1) using a first magnetic sensor structure comprising a first set of at least two horizontal Hall elements arranged near a periphery of a first IMC (IMC1) situated at a first sensor location; b) measuring a second magnetic field component (e.g. Bx2) using a second magnetic sensor structure comprising a second set of at least two horizontal Hall elements arranged near a periphery of a second IMC (IMC2) situated at a second sensor location spaced from the first sensor location; c) optionally measuring or determining or estimating one or more temperatures (e.g. T, T1, T2) of the first and second magnetic sensor; d) determining a difference (e.g. DIFF12x) between the first and the second magnetic field component (e.g. Bx1,Bx2), e.g. in accordance with the formula: DIFF12x=(Bx2-Bx1); e.g. likewise DIFF12y=(By2-By1); e.g. likewise DIFF12z=(Bz2-Bz1); e) determining a correction term (e.g. CORR12x) of the first and the second magnetic field component (e.g. Bx1, Bx2), e.g. in accordance with the formula: CORR12x=f1(Bx1,Bx2), e.g. CORR12x=w1*(Bx1+Bx2), or CORR12x=w1(T)*(Bx1+Bx2), or CORR12x=w1(T1)*Bx1+w1(T2)*Bx2; e.g. likewise CORR12y=f2(By1,By2), e.g. CORR12y= w2*(By1+By2), or CORR12y=w2(T)*(By1+By2), or CORR12y=w2(T1)*By1+w2(T2)*By2; e.g. likewise CORR12z=f3(Bz1,Bz2), e.g. CORR12z=w3*(Bz1+Bz2), or CORR12z=w3(T)*(Bz1+Bz2), or CORR12z=w3(T1)*Bz1+w3(T2)*Bz2; where w1,w2,w3 are scaling factors or scaling functions determined during a calibration procedure; The scaling factors or scaling function typically have an absolute value smaller than 0.20 or smaller than 0.15 or smaller than 0.10; f) determining a gradient (e.g. dBxdx) as a value proportional to a combination (e.g. a sum or subtraction) of said difference (e.g. DIFF12x) and said correction term (e.g. CORR12x), e.g. in accordance with the formula: dBxdx = DIFF12x + CORR12x; Likewise dBydx = DIFF12y + CORR12y; Likewise dBzdx = DIFF12z + CORR12z.

A flow-chart of this method is illustrated in FIG. 9. The first and second set of horizontal Hall elements may have different magnetic sensitivities, e.g. at least one first sensor of the first set having a first sensitivity, and at least one second sensor of the second set having a second sensitivity that is at least 1% different (e.g. larger or smaller).

According to a sixth aspect, the present invention also provides a method of determining a linear or an angular position of a sensor device relative to a magnetic source; wherein the sensor device comprises a first magnetic sensor structure located at a first sensor location and a second magnetic sensor structure located at a second sensor location spaced from the first sensor location, each magnetic sensor structure comprising an integrated magnetic concentrator (IMC) and at least two horizontal Hall elements arranged near a periphery of the respective IMC, the method comprising the steps of: a) determining a first gradient (e.g. G1) by applying the method of the fifth aspect using a first combination of sensor signals obtained from the magnetic sensors of the sensor device; b) determining a second gradient (e.g. G2) by applying the method of the fifth aspect using a second combination of sensor signals obtained from the magnetic sensors of the sensor device, different from the first combination; c) determining a linear or an angular position based on a ratio of the first gradient (e.g. dBxdx) and the second gradient (e.g. dBzdx).

The linear or angular position may be determined as f(K5*G1/G2), e.g. as $\alpha$=atan2(K2*G1,G2), where K5 is a predefined constant, which may depend on the relative position and/or orientation of the sensor device relative to the magnetic source.

Particular and preferred aspects of the invention are set out in the accompanying independent and dependent claims. Features from the dependent claims may be combined with features of the independent claims and with features of other dependent claims as appropriate and not merely as explicitly set out in the claims. These and other aspects of the invention will be apparent from and elucidated with reference to the embodiment(s) described hereinafter.

## Brief description of the drawings

FIG. 1(a) shows an illustrative example of a sensor arrangement and formulas for determining a magnetic field gradient, proposed by the present invention.

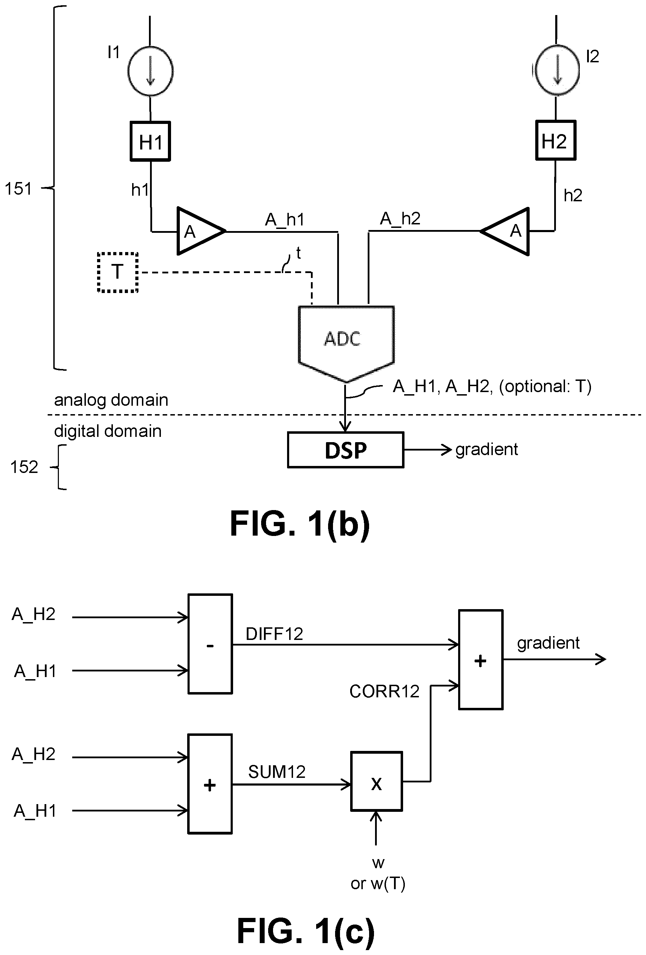

FIG. 1(b) shows a schematic block diagram of an illustrative example of a circuit that can be used for biasing and read-out of the sensor arrangement of FIG. 1(a).

**FIG. 1(c)** shows a data-flow diagram illustrating a possible way of determining a gradient as proposed by the present invention.

FIG. 1(a) to FIG. 1(c) may be jointly referred to as **FIG. 1.**

**FIG. 2** and **FIG. 3** show other illustrative examples of a sensor arrangement and formulas for determining a magnetic field gradient, proposed by the present invention.

**FIG. 4(a)** shows an illustrative example of a position sensor arrangement comprising a magnet and a sensor device, and

**FIG. 4(b)** shows an illustrative example of a sensor arrangement and formulas for determining an angular position based on two magnetic field gradients, proposed by the present invention.

**FIG. 4(c)** shows a schematic block diagram of an illustrative example of a circuit that can be used for biasing and read-out of the sensor arrangement of FIG. 4(b), and for determining a gradient value, and/or a value derived therefrom (e.g. a current).

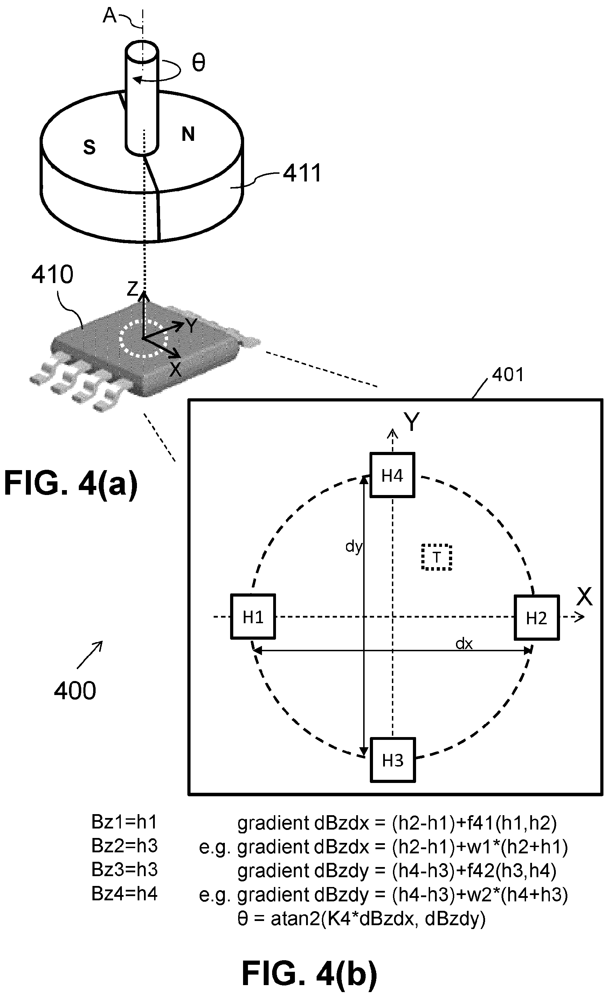

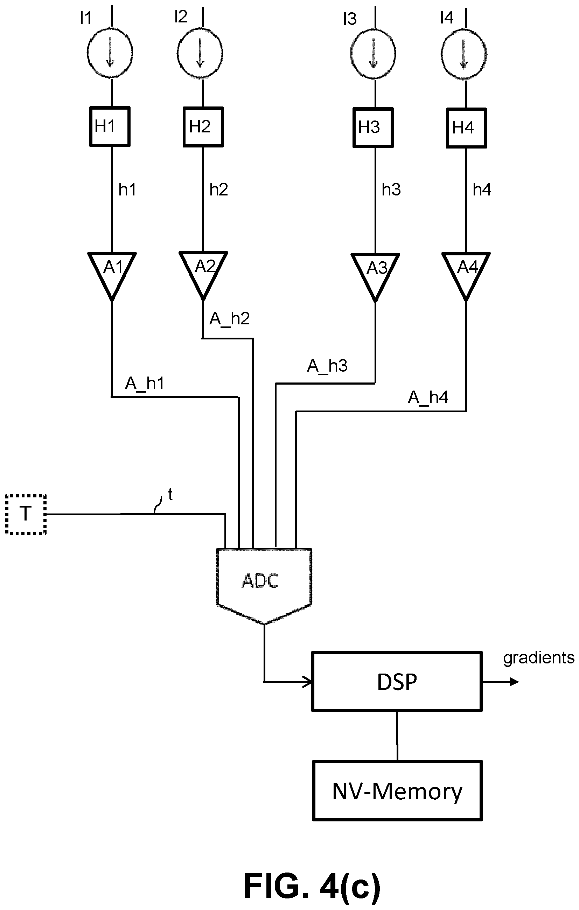

FIG. 4(a) to FIG. 4(c) may be jointly referred to as **FIG. 4.**

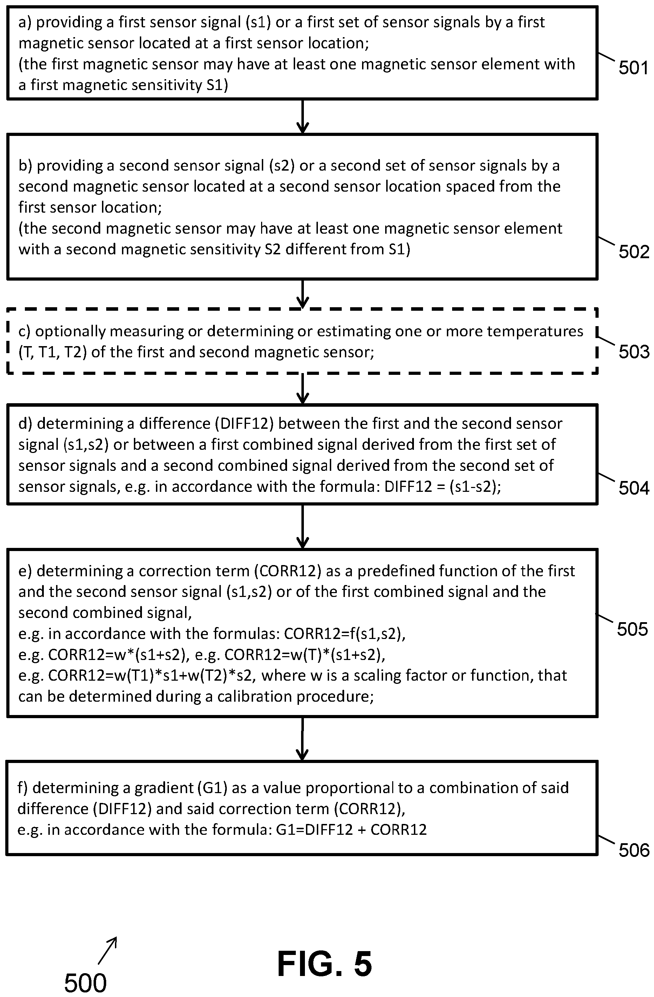

**FIG. 5** shows a flow-chart of a method of determining a magnetic field gradient, proposed by the present invention, e.g. as can be used in conjunction with the sensor arrangement of FIG. 1(a) or FIG. 2 or FIG. 3 or FIG. 4(b).

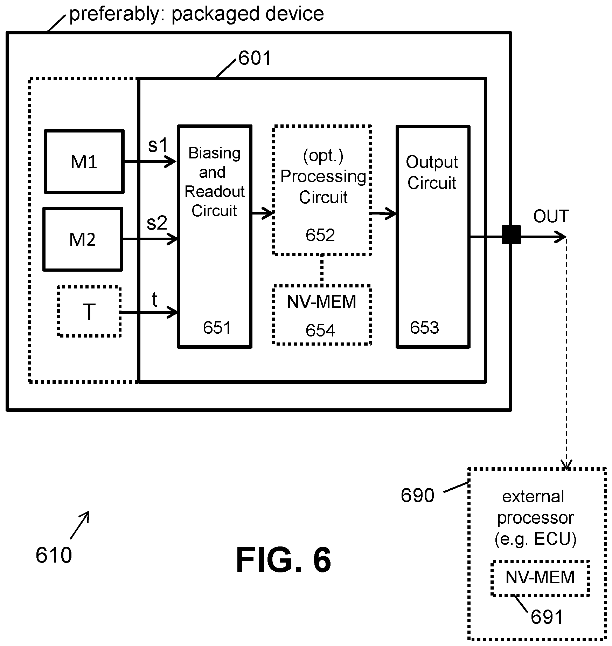

**FIG. 6** shows a high-level block diagram of a sensor device comprising at least two magnetic sensors and a processing circuit, proposed by the present invention. **FIG. 6** also shows a high-level block diagram of a sensor system comprising a sensor device and an external processor connected thereto.

**FIG. 7(a)** shows an illustrative example of a sensor arrangement and formulas for determining one or more magnetic field gradients using a so called "dual disk structure with 2D magnetic pixels", proposed by the present invention.

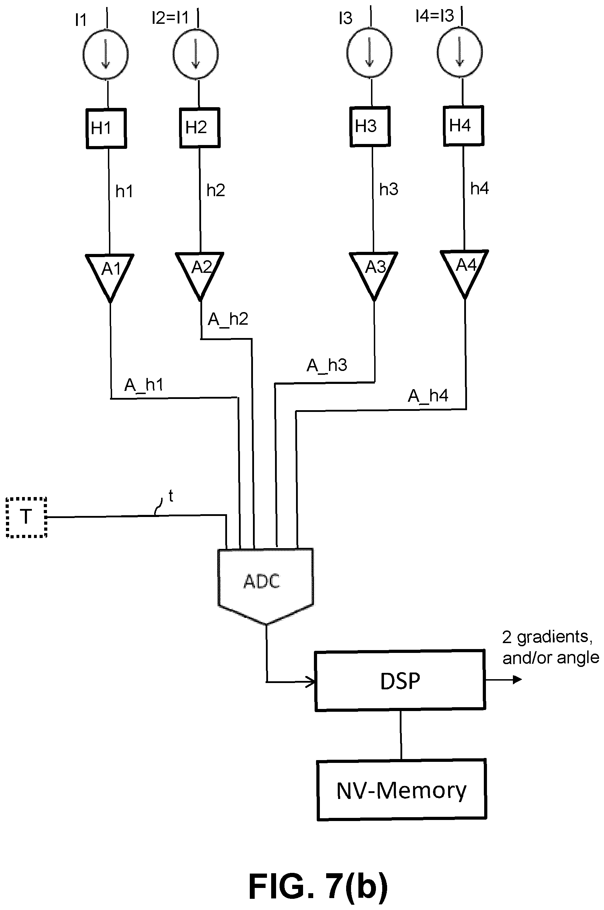

**FIG. 7(b)** shows a schematic block diagram of an illustrative example of a circuit that can be used for biasing and read-out of the sensor arrangement of FIG. 7(a), and for determining one or more gradient values, and/or a value derived therefrom (e.g. a linear or angular position).

FIG. 7(a) and FIG. 7(b) may be jointly referred to as **FIG. 7.**

**FIG. 8(a)** shows an illustrative example of a sensor arrangement and formulas for determining one or more magnetic field gradients using a so called "dual disk structure with 3D magnetic pixels", proposed by the present invention.

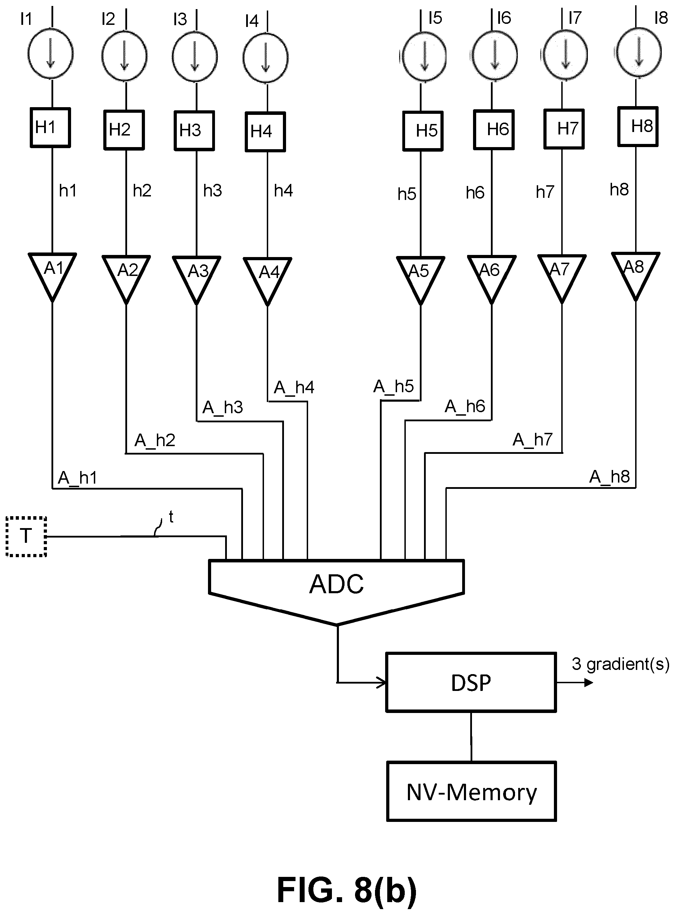

**FIG. 8(b)** shows a schematic block diagram of an illustrative example of a circuit that can be used for biasing and read-out of the sensor arrangement of FIG. 8(a), and for determining one or more gradient values, and/or a value derived therefrom (e.g. a linear or angular position).

FIG. 8(a) and FIG. 8(b) may be jointly referred to as **FIG. 8.**

**FIG. 9** shows a flow-chart of a method of determining one or more magnetic field gradients, proposed by the present invention, e.g. as can be used in conjunction with the sensor arrangement of FIG. 7(a) or FIG. 8(a).

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

**Detailed description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document the reference "T" is used to indicate both a temperature sensor, as well as a temperature signal obtained therefrom. Sometimes a lowercase letter "t" is used to indicate an analog temperature signal, and an uppercase letter "T" is used to indicate a digital temperature signal, but this distinction is not always made. It shall be clear from the context which meaning is intended.

In this document the reference "T1" is used to indicate a first temperature sensor or a first temperature signal or value, and the reference "T2" is used to indicate a second temperature sensor or a second temperature signal or value.

In this document the reference "I1" is used to indicate both a first current source, as well as a first current signal. It shall be clear from the context which meaning is intended.

In this document the reference "A1" is used to indicate both a first amplifier, as well as a first amplifier gain. It shall be clear from the context which meaning is intended.

Where in the present invention reference is made to a "current source", what is meant is a component or circuit capable of providing a current to a node, substantially independent on the voltage of that node. Typically a current source has a relatively large output impedance, e.g. at least 1 K Ohm, or at least 10 K Ohm.

In this document invention, the expression "voltage related magnetic sensitivity" refers to the value "S" as used for example in the formula: $v=S*B$, where v=voltage signal, 5 = magnetic sensitivity, B = magnetic field strength. The voltage related magnetic sensitivity can be expressed in [Volts/Tesla], and can be used if the magnetic sensor device is biased with a voltage source.

In this document, the expression "current related magnetic sensitivity" refers to the value "s" as used for example in the formula: $v=s*I*B$, where v=voltage signal, s = current related magnetic sensitivity, I = current, B = magnetic field strength. The current related magnetic sensitivity can be expressed in [Volts/(Ampère*Tesla)], and can be used if the magnetic sensor device is biased with a current source.

In this document, the expression "magnetic sensitivity" may refer to the "voltage related magnetic sensitivity" if the magnetic sensors are biased with a voltage source, and may refer to the "current related magnetic sensitivity" if the magnetic sensors are biased with a current source.

In this document, the term "magnetic sensor" or "magnetic sensor structure" may refer to a sensor comprising at least a magnetic sensing element (e.g. Hall element, magneto resistive element) for sensing (measuring) at least a component of a magnetic field, so as to provide at least a sensor signal (typically in an analog form) representing the sensed component of the magnetic field. In certain embodiments of the present invention, the term "magnetic sensor" or "magnetic sensor structure" may refer for example to an arrangement comprising a single horizontal Hall element, or a single vertical Hall element, or a combination of a horizontal Hall element and one or two or four vertical Hall elements arranged near (an) edge(s) of the horizontal Hall element, or a combination of a disk shaped integrated magnetic flux concentrator (IMC) and two horizontal Hall elements arranged near the periphery of the IMC angularly spaced by 180°, or a combination of a disk shaped IMC and four horizontal Hall elements arranged near the periphery of the IMC angularly spaced by multiples of 90°.

In this document, the expression "1D magnetic pixel" typically refers to a magnetic sensor element capable of measuring only one magnetic field component.

In this document, the expression "2D magnetic pixel" typically refers to a magnetic sensor structure capable of measuring only two orthogonal magnetic field components.

In this document, the expression "3D magnetic pixel" typically refers to a magnetic sensor structure capable of measuring three orthogonal magnetic field components.

In this document, the expression "in-plane component of a magnetic field vector" and "projection of the magnetic field vector in the sensor plane" mean the same. If the sensor device is or comprises a semiconductor substrate, this also means "magnetic field components parallel to the semiconductor plane". In this document, in-plane components are typically labelled Bx or By.

In this document, the expression "out-of-plane component of a vector" and "Z component of the vector" and "projection of the vector on an axis perpendicular to the sensor plane" mean the same. In this document, out-of-plane components are typically labelled Bz.

In this document, the expression "first degree polynomial" and "first order polynomial" mean the same.

Embodiments of the present invention are typically described using an orthogonal coordinate system which is fixed to the sensor device, and having three axes X, Y, Z, where the X and Y axis are parallel to the substrate, and the Z-axis is perpendicular to the substrate.

In this document, the expression "spatial derivative" or "derivative" or "spatial gradient" or "gradient" are used as synonyms. A magnetic field difference can be determined as a difference between two magnetic field component values measured at two locations spaced apart in the X-direction, and in theory the gradient is calculated as said difference divided by the distance "dx" between the sensor locations, but in practice the division by "dx" is often omitted, because the measured signals need to be scaled anyway. Hence, in the context of the present invention, the magnetic field difference (∆Bx) and magnetic field gradient dBx/dx are used interchangeably. In this document the notation dBxdx is also used when referring to a gradient of the Bx component along the X-direction.

In this document, the notation dBzdx can be used to refer to a gradient of the Bz component along the X-direction. Likewise, the notation dBzdy can be used to refer to a gradient of the Bz component along the Y-direction, etc.

In this document, horizontal Hall plates are typically referred to by H1, H2, etc., and signals obtained from horizontal Hall plates are referred to as h1, h2, etc.

In this document, vertical Hall plates are typically referred to by V1, V2, etc., and signals obtained from vertical Hall plates are referred to as v1, v2, etc.

In this document, the expression "a scaled sum of two signals s1, s2" means a scale version of the sum of said two signals, as mathematically expressed as w*(s1+s2), w being a non-zero scaling factor.

In this document, IMC means "integrated magnetic concentrator".

In this document, ADC means "analog to digital convertor".

In this document, DSP means "digital signal processor" or "digital processing circuit". This may comprise a programmable processor.

In this document "NV-memory" means "non-volatile memory", e.g. flash memory.

The present invention relates to devices and methods for measuring at least one magnetic field gradient of a magnetic field, e.g. a magnetic field generated by a permanent magnet arranged in the vicinity of the sensor device, e.g. at a distance of at most 10.0 mm, or at most 5.0 mm. Many of such arrangements are known in the art, but the main focus of the present invention is not on finding a new arrangement of a sensor device and a particular magnet, but rather on how to measure a magnetic field gradient more accurately, using a magnetic sensor device that comprises magnetic sensors having magnetic sensitivities that are not matched to each other, hence are slightly different from each other.

**FIG. 1(a)** shows a semiconductor substrate 101 comprising a sensor arrangement 100 comprising two horizontal Hall elements H1, H2, which are spaced apart over a distance dx along a predefined axis X. The first Hall element H1 is located at position X1, and provides a first sensor signal h1 proportional to a magnetic field component Bz1 oriented in a direction Z perpendicular to the substrate. The second Hall element H2 is located at position X2, and provides a second sensor signal h2 proportional to a magnetic field component Bz2 also oriented in the direction Z perpendicular to the substrate. The sensor signals are typically amplified before they are digitized. If abstraction is made of the scaling factor or amplification factor, it can be written that h1=Bz1, and h2=Bz2. It is noted that the two magnetic sensors do not need to be implemented on a single semiconductor substrate, but could also be implemented on separate semiconductor substrates, e.g. two Ga-As substrates as part of a WLP package, or two Ga-As substrates mounted next to a CMOS substrate on a lead frame, or two Ga-As substrates mounted on top of a CMOS substrate.

In the prior art, a gradient of the magnetic field component Bz along the X-direction is typically determined by making sure that the magnetic sensitivity of the two magnetic sensors H1 and H2 are substantially identical within a predefined tolerance margin, and/or by making sure that the overall sensitivity of the signal paths containing the two magnetic sensors are substantially identical within said tolerance margin, before subtracting the signals in the analog or in the digital domain. Examples of this technique can be found inter alia in US2010237859(A1) where the biasing sources of two sensors are adjusted by two control loops, or as described in U52019079142(A1) where one sensor is considered a reference sensor, and other sensors are adjusted to the reference sensor. These solutions require additional hardware e.g. to create an adjustable biasing source and/or require an additional control mechanism.

The inventors of the present invention were confronted with the task of determining a gradient with high accuracy, but they took a radically different approach. Instead of adding extra hardware and/or a control mechanism to make the magnetic sensitivities of the magnetic sensors or the overall gain of the signal paths containing them equal to each other, they surprisingly found a solution that provides highly accurate results, even when the magnetic sensitivities of the two sensors or the overall gains of the signal paths device more than the above mentioned tolerance margin, e.g. due to manufacturing tolerances, material non-idealities, etc. During experiments, they noticed that the magnetic field difference (h2-h1) is a good approximation for the gradient in the absence of a magnetic disturbance field, or when the disturbance field is much smaller than the field to be measured, e.g. when measuring these signals in close vicinity to a two-pole magnet; but they also noticed that this accuracy quickly degraded in the presence of a magnetic disturbance field. Instead of trying to find ways to decrease the influence from the magnetic disturbance field, they studied the influence closer, and after performing many measurements on various sensor devices, and analysing the measurement data, they discovered that the difference signal (h2-h1) changes with the magnitude of the external disturbance field, in a degree that may differ for each sensor device. They further discovered that, even though the magnitude of the magnetic disturbance field is unknown, and despite the magnetic sensitivities of the two sensors being different, an accurate value of the magnetic field gradient can be determined by correcting the difference (h2-h1) with a correction term CORR, wherein the correction term can be determined based on the measured signals, e.g. as a function of the measured signals, and optionally also one or more temperature signal. The correction term can e.g. be expressed as a polynomial expression of the measured signals h1, h2. In the cases they investigated, surprisingly good results were obtained using a first degree polynomial, i.e. a linear combination of the measured signals, or even with a "scaled sum" of the measured signals, e.g. using the following formula:

$$\text{gradient } dBzdx = (h2\text{-}h1) + w*(h1+h2) \qquad [1]$$

where h1 and h2 are the sensor signals, or signals derived therefrom (e.g. after amplification and/or digitization), and "w" is a scaling factor or a weight factor, which can be determined for each individual sensor device.

It came as a surprise that it is possible to determine an accurate value of the gradient based on the signals h1 and h2, moreover as a first degree polynomial, e.g. in form of a linear combination, or of a scaled sum ,of these signals, especially when fully realizing that the magnetic sensors or their signal paths were not matched, and considering that (h1+h2) does not only represent the disturbance field, but also includes the field to be measured (e.g. generated by a magnet). This solution goes against a common believe or a prejudice in the field, because until now, it was believed to be impossible to determine the gradient value accurately without first matching the sensors or the signal paths.

The inventors also found a very simple way to determine the value of the scaling factor "w". Rather than applying a known gradient signal (e.g. generated by a dipole) and a known disturbance field (e.g. generated by a big magnet or by a current conductor), it is possible to determine "w" by placing the sensor device in a constant magnetic field, because in this field the "real gradient" is exactly zero, but if the two sensitivities or the overall gain of the signal paths are not identical, the value of (h2-h1) will not be zero. Based on this insight, the value of "w" can be determined by measuring or determining (h2-h1) and by measuring or determining (h2+h1) during a calibration procedure, and by assigning the ratio (h1-h2)/(h2+h1) to "w", such that the formula [1] becomes zero. This value of "w" can then be stored in a non-volatile memory of the sensor device, or a non-volatile memory of an external processor connected to the sensor device).

During actual use of the sensor device, the value of "w" can be retrieved from said non-volatile memory, and can be applied in formula [1] to determine the gradient. This can be achieved for example by determining the difference (h2-h1) in the analog domain, and by amplifying and digitizing this difference signal (yielding a value DIFF), and by determining the sum (h1+h2) in the analog domain, and by amplifying and digitizing this sum signal (yielding a value SUM), and by calculating the gradient as follows: gradient = DIFF + w*SUM.

It is also possible to amplify and digitize the individual signal h1 (yielding A_H1) and to amplify and digitize the individual signal h2 (yielding A_H2), and to calculate a difference DIFF=(A_H1-A_H2) and a sum SUM=(A_H1+A_H2) in the digital domain, and to calculate the gradient the gradient as follows: gradient = DIFF + w*SUM.

Experiments have shown that the above described technique provides excellent results, and is a major improvement over existing methods, and does not require complex hardware (e.g. adjustable biasing source, and/or adjustable amplifier, and/or a control-loop), see e.g. FIG. 1(b).

It is also possible to determine the value of the scaling factor "w" for different temperatures during said calibration procedure, e.g. for at least two different temperatures, or for three different temperatures, and to store these multiple values of "w" in said non-volatile memory. During actual use of the sensor device, a suitable value for the scaling factor "w" can then be determined by measuring a temperature of the sensor device, and by interpolating the scaling factors stored in the non-volatile memory. The following notation can be used in this case:

$$\text{gradient dBzdx} = (h2\text{-}h1) + w(T)*(h1+h2) \qquad [2]$$

where h1 and h2 are the sensor signals, or signals derived therefrom (e.g. after amplification and/or digitization), and "w(T)" is a predefined function of temperature, which can be determined for each individual sensor device. This predefined function can be stored in the non-volatile memory in any appropriate manner, e.g. as a look-up table, or by means of coefficients of a polynomial function, or by means of coefficients of a piece-wise linear approximation, etc. Formula [2] is particularly useful if the temperature of the first and second magnetic sensor are substantially equal, and the sensor device needs to operate over a relatively large temperature range, e.g. from -20°C to +120°C or larger.

If the temperature of the two magnetic sensors is not substantially equal, e.g. if the sensor device is used in an environment with a relatively large temperature gradient, the gradient may be determined by measuring a first temperature T1 for the first magnetic sensor, and a second temperature T2 for the second magnetic sensor, and by determining the gradient as:

$$\text{gradient dBzdx} = (h2\text{-}h1) + w(T1)*h1 + w(T2)*h2 \qquad [3]$$

It is noted that only one scaling function w(T) needs to be determined during the calibration procedure, because the calibration procedure is preferably performed in a controlled environment where T1 is substantially equal to T2, but that two different scaling factors w(T1) and w(T2) may be derived therefrom during actual use of the device. Formula [3] may be especially useful for sensor devices wherein the two magnetic sensors H1, H2 are not integrated in a single semiconductor substrate 101.

These are the main principles of the present invention, explained for a simple sensor structure consisting of two horizontal Hall elements. But the same principles can also be applied to other sensor structures, as will be described further.

**FIG. 1(b)** shows a schematic block diagram of an illustrative example of a circuit 151 that can be used for biasing and readout of the two horizontal Hall elements H1, H2 of FIG. 1(a), and a processing circuit 152 (e.g. comprising a DSP) for determining a magnetic field gradient based on the measured signals. The circuit of FIG. 1(b) comprises:

- a first magnetic sensor H1 (e.g. a first horizontal Hall element) located at a first sensor location X1, e.g. as illustrated in FIG. 1(a), arranged for providing a first sensor signal h1 indicative of a first magnetic field component Bz1 oriented in a first direction Z;
- a second magnetic sensor H2 (e.g. a second horizontal Hall element) located at a second location X2, e.g. as illustrated in FIG. 1(a), spaced from the first sensor location X1, (e.g. by a distance dx in the range from 0.5 mm to 3.0 mm, or from 0.8 mm to 2.5 mm, or from 1.0 mm to 2.5 mm) and arranged for providing a second sensor signal h2 indicative of a second magnetic field component Bz2 oriented in said first direction Z;
- optionally a single temperature sensor configured for measuring a temperature (T), and for providing a temperature signal "t";
- at least one biasing source for biasing the first and the second magnetic sensor with a predefined biasing signal, e.g. a predefined current, or a predefined voltage. The biasing current is preferably generated by a temperature-compensated current generator circuit, known per s6 in the art;

In the example shown in FIG. 1(b), the circuit has two separate biasing sources I1, I2, but that is not required for the present invention to work, and a single biasing source may also be used. If two separate biasing sources are used, they do not need to be adjustable, and they do not need to provide exactly the same signal (as explained above).

- at least one amplifier for amplifying the first magnetic sensor signal h1 with a first predefined gain A yielding a first amplified sensor signal A_h1, and for amplifying the second magnetic sensor signal h2 with a predefined gain A yielding a second amplified sensor signal A_h2;

In the example shown in FIG. 1(b), the circuit has two separate amplifiers, but that is not required for the present invention to work, and a single amplifier can be used in a time-multiplexed manner. If two separate amplifiers are used, they do not need to be adjustable, and they do not need to apply exactly the same gain (as explained above).

- at least one analog-to-digital converter (ADC) for converting the first amplified signal A_h1 and the second amplified signal A_h2, (e.g. in a time-multiplexed manner).

This is represented schematically by an ADC having multiple inputs, but it would also be possible to use an analogue multiplexer in front of the ADC. Such details are omitted from the drawings for illustrative purposes. In the example shown, the temperature signal "t" may also be digitized using this ADC, but that this not absolutely required, and it is possible to omit the temperature sensor, or to use two temperature sensors, and/or to use a second ADC, and/or to use one or more temperature sensors that provide a digital output signal.

- a digital processing circuit 152 (e.g. comprising or consisting of a DSP) connected downstream of the analog-to-digital convertor ADC.

The digital processing circuit 152 may be configured for determining the gradient signal.

In the example of FIG. 1(b) the first sensor signal h1 is amplified into A_h1, and then digitized into A_H1, and likewise, the second sensor signal h2 is amplified into A_h2, and then digitized into A_H2, and the values A_H1 and A_H2 are added (to yield SUM12) and subtracted (to yield DIFF12) in the digital domain. The digital processing circuit 152 may be configured:

i) for determining a difference DIFF12 between the first amplified sensor signal A_H1 and the second amplified sensor signal A_H2, in accordance with the formula: DIFF12 = (A_H1 - A_H2); and

ii) for determining a correction term CORR12 by adding the first amplified sensor signal A_H1 and the second amplified sensor signal A_H2 yielding a sum SUM12, and by multiplying this sum with a scaling factor "w" or w(T) yielding the correction term CORR12; and

iii) for determining the gradient as a combination of DIFF12 and the correction term CORR12, e.g. in accordance with the formula: gradient = DIFF12 + CORR12,

but as described above, the present invention is not limited to determine the correction term as a "scaled sum", and in a variant the correction term is calculated as a linear combination of A_H1 and A_H2, or even as a polynomial expression of A_H1 and A_H2, and optionally also T, or T1 and T2.

Moreover, the present invention is not limited to the illustrated structures of the readout circuit 151 and the processing circuit 152 (separation between analog and digital operations), i.e. some up to all of the above described operation i)-iii) can be executed in the analog domain by the readout circuit, notably by means of one or more analog processing circuit(s).

In a first exemplary alternative, the readout circuit can comprise at least one analog processing circuit for determining the difference between the first sensor signal and the second sensor signal (e.g. DIFF12 of operation i). The difference signal can then be digitized by the analog-to-digital convertor ADC so as the digital processing circuit can determine the gradient and the correction term (e.g. CORR12 and gradient according to above-described operations ii) and iii) ).

In a second exemplary alternative, the readout circuit can comprise at least one analog processing circuit for determining:

a) the correction term, or

b) a combination (e.g. a sum, a linear combination) of the first sensor signal and the second amplified sensor signal in view of the determination of the correction term (e.g. CORR12 of operation ii). The combination/correction signal can then be digitized by the analog-to-digital convertor ADC so as the digital processing circuit can determine:

in case a) the correction term based on the digitized combination signal if needed, and

the difference and the accurate gradient (e.g. CORR12, DIFF12 and gradient according to above-described operations).

In a third exemplary alternative, the readout circuit can comprise at least one analog processing circuit for determining: the correction term or such combination, and such difference. The signals can then be digitized by the analog-to-digital convertor ADC so as the digital processing circuit can then determine the gradient. Even if the temperature sensor is illustrated as providing an analog signal, some embodiments can comprise a digital temperature sensor for sensing a predefined portion or element of the magnetic sensor device and providing a digital signal - directly (i.e. without the ADC) - to the digital processing processor (DSP).

FIG. 1(c) shows a data-flow diagram illustrating this technique for a "scaled sum", but the present invention is not limited hereto, and in a variant (not shown), the digital value DIFF12 may also be obtained by subtracting the values h1, h2 in the analog domain (yielding an analog signal "diff12"), and to amplify and digitize this difference signal (yielding DIFF12), and/or the digital value SUM12 may be obtained by adding the values h1, h2 in the analog domain (yielding a sum signal "sum12"), and to amplify and digitize this sum signal (yielding SUM12).

Other variants are also possible, for example, the biasing and readout circuit may be configured to provide three signals to the at least one amplifier: (i) h1, (ii) h2, (iii) the analog difference (h1-h2). In this case, the digital circuit does not have to calculate DIFF12, because the ADC will provide the value DIFF12 directly.

**FIG. 2** shows another illustrative example of a semiconductor substrate 201 comprising a sensor arrangement comprising two vertical Hall elements V1, V2, oriented with their axes of maximum sensitivity in the X-direction, and spaced apart in the X-direction by a predefined distance dx, e.g. in the range from 0.50 mm to 3.00 mm, or from 1.0 mm to 2.5 mm.

The sensor arrangement of FIG. 2(a) can be seen as a variant of the sensor arrangement of FIG. 1(a), where the horizontal Hall elements H1, H2 are replaced by vertical Hall elements V1, V2. The vertical Hall element V1 provides a first sensor signal v1 indicative of a first magnetic field component Bx1 oriented in the X-direction at a first sensor location, and the vertical Hall element V2 provides a second sensor signal v2 indicative of a second magnetic field component Bx2 oriented in the X-direction at a second sensor location. Everything else described above is also applicable here, mutatis mutandis, for example, it is not required that the two magnetic sensors are implemented on a single semiconductor substrate, but they could e.g. also be implemented on separate semiconductor substrates.

Similar as described above, if the magnetic sensitivity S1 of V1 and the magnetic sensitivity S2 of V2 would be identical, then the magnetic field gradient dBxdx can be determined as a value proportional to (v2-v1). If abstraction is made of the scaling factor, because the sensor signals need to be scaled anyway, it can be written that gradient dBxdx = (v2-v1).

As explained above, in practice, however, the magnetic sensitivities S1 and S2 will always be somewhat different from each other, even if exactly the same layout symbol is used, and even if they are biased by sources having exactly the same layout, inter alia because of process tolerances and material imperfections, and as a consequence, the value (v2-v1) is a good approximation of the real gradient in the absence of an external disturbance field, but will become increasingly more inaccurate in the presence of a disturbance field with increasing amplitude.

The present invention proposes to determine the gradient dBxdx in a different manner, namely as a combination (e.g. a sum or difference) of the difference (DIFF12) between the sensor signals and a correction term (CORR12) of the sensor signals, e.g. in accordance with the formula:

$$\text{gradient dBxdx} = (v2-v1) + f2(v1,v2) \qquad [4],$$

where f2() is a predefined function, v1 is the first sensor signal, and v2 is the second sensor signal; or if the correction term is approximated by a "scaled sum", in accordance with the formula:

$$\text{gradient dBxdx} = (v2-v1) + w*(v2+v1) \qquad [5]$$

wherein dBxdx is the gradient of Bx oriented in the X-direction along the X-direction, v2 is the second sensor signal, v1 is the first sensor signal, and w is a scaling factor which can be determined during a calibration procedure.

During the calibration procedure, the value of "w" is preferably determined by applying a constant magnetic field (i.e. a field without a magnetic field gradient), and by assigning the value of (v1-v2)/(v1+v2) to "w", such that the formula [5] becomes zero. The value of "w" is preferably stored in a non-volatile memory of the sensor device itself, or of a non-volatile memory connected to the sensor device, or of a non-volatile memory of another processor connected to the sensor device.

The same or similar circuit as shown **in FIG. 1(b)** can be used for biasing and reading out the signals from the vertical Hall elements V1, V2, and/or the same or similar data-flow diagram as shown in FIG. 1(c) can be used to determine the gradient.

Similar as described in FIG. 1(b) a single biasing source or two separate biasing sources can be used, and/or a single or two amplifiers can be used to amplify the magnetic sensor signals. It is a major advantage that a single biasing source can be used, or two independent biasing sources can be used, even if they provide slightly different biasing signals, as opposed to a biasing circuit comprising one independent and one adjustable biasing source, because such a biasing circuit is more complex in terms of hardware and/or control software. Likewise, it is a major advantage that only a single amplifier can be used, or two separate amplifiers, even if they have slightly different gains.

As described above, a gradient value according to formula [4],[5] can be determined without a temperature measurement. In this case, it suffices to determine a single value of "w" during the calibration procedure.

In a variant, the sensor arrangement further comprises a temperature sensor T (e.g. located at a distance d1 smaller than dx*70% from V1, and at a distance d2 smaller than dx*70% from V2), and at least two or at least three different values of "w" are determined for at least two or at least three different temperatures, and these values are stored in a non-volatile memory, e.g. in the form of a look-up table. During actual use of the sensor device, the gradient can then be determined using the following formula:

$$\text{gradient dBxdx} = (v2-v1) + w(T)*(v2+v1) \qquad [6]$$

wherein w(T) is the temperature dependent scaling factor.

In another variant, the sensor arrangement further comprises two temperature sensors T1 and T2 (e.g. T1 located at a distance d1 smaller than dx*40% from V1, and T2 located at a distance d2 smaller than dx*40% from V2), and at least two or at least three different values of "w" are determined for at least two or at least three different temperatures, and these values are stored in a non-volatile memory, e.g. in the form of a look-up table. During actual use of the sensor device, the gradient can then be determined using the following formula:

$$\text{gradient dBxdx} = (v2\text{-}v1) + w(T1)*v1 + w(T2)*v2 \qquad [7]$$

wherein w(T) is the temperature dependent scaling factor.

FIG. 3 shows another illustrative example of a semiconductor substrate 301 comprising a sensor arrangement comprising two vertical Hall elements V1, V2, oriented with their axes of maximum sensitivity in the Y-direction, and spaced apart in the X-direction by a predefined distance dx, e.g. in the range from 0.50 mm to 3.00 mm, or from 1.0 mm to 2.5 mm.

The sensor arrangement of FIG. 3 can be seen as a variant of the sensor arrangement of FIG. 2, where the vertical Hall elements are rotated by 90° about the Z-axis, and are configured for measuring a first magnetic field component By1 oriented in the Y-direction at the first sensor location, and a second magnetic field component By2 oriented in the Y-direction at the second sensor location. This sensor arrangement allows to determine a magnetic field gradient of By oriented in the Y-direction along the X-direction, sometimes written as dBy/dx, or as dBydx because no division by the distance "dx" is performed in practice. Everything else described for FIG. 2 is also applicable here, mutatis mutandis.

FIG. 1 to FIG. 3 illustrate how a single magnetic field gradient can be determined using the principles of the present invention. The sensor arrangement of FIG. 1(a) has two 1D magnetic pixels each capable of measuring a Bz signal, perpendicular to the semiconductor substrate(s) in which they are implemented. The sensor arrangement of FIG. 2 has two 1D magnetic pixels each capable of measuring a Bx signal, parallel to the semiconductor substrate(s) in which they are implemented. The sensor arrangement of FIG. 3 has two 1D magnetic pixels each capable of measuring a By signal, parallel to the semiconductor substrate(s) in which they are implemented.

It is known to make a 2D magnetic pixel capable of measuring Bz and Bx, by arranging a horizontal Hall element and a vertical Hall element oriented with its axis of maximum sensitivity in the X-direction. By combining the sensors and the formulas of FIG. 1(a) and FIG. 2, the present invention provides a sensor device capable of determining two magnetic field gradients dBzdx and dBxdx. It is also possible to arrange two vertical Hall elements on opposite sides of each horizontal Hall element. In this case the sensor signals of these two vertical Hall elements can be added or averaged.

It is known to make a 2D magnetic pixel capable of measuring Bz and By, by arranging a horizontal Hall element and a vertical Hall element oriented with its axis of maximum sensitivity in the Y-direction. By combining the sensors and the formulas of FIG. 1(a) and FIG. 3, the present invention provides a sensor device capable of determining two magnetic field gradients dBzdx and dBydx. It is also possible to arrange two vertical Hall elements on opposite sides of each horizontal Hall element. In this case the sensor signals of these two vertical Hall elements can be added or averaged.

It is known to make a 2D magnetic pixel capable of measuring Bx and By, by arranging one vertical Hall element oriented with its axis of maximum sensitivity in the X-direction, and another vertical Hall element oriented with its axis of maximum sensitivity in the Y-direction. By combining the sensors and the formulas of FIG. 2 and FIG. 3, the present invention provides a sensor device capable of determining two magnetic field gradients dBxdx and dBydx. It is also possible to arrange four vertical Hall elements on the sides of a virtual square. In this case the sensor signals of the vertical Hall elements oriented in the same direction can be pairwise added or averaged.

It is known to make a 3D magnetic pixel capable of measuring Bx, By and Bz, by arranging one horizontal Hall element and one vertical Hall element oriented with its axis of maximum sensitivity in the X-direction, and another vertical Hall element oriented with its axis of maximum sensitivity in the Y-direction. By combining the sensors and the formulas of FIG. 1 and FIG. 2 and FIG. 3, the present invention provides a sensor device capable of determining three magnetic field gradients dBxdx, dBydx and dBzdx. It is also possible to arrange four vertical Hall elements near the sides of each horizontal Hall element. In this case the sensor signals of the vertical Hall elements oriented in the same direction can be pairwise added or averaged.

It is a major advantage that in all of these combinations, the gradients can be accurately determined without having to match the magnetic sensitivities of the magnetic sensor elements, or the overall gain of the signal paths comprising them.

While not explicitly shown, it shall be clear for the skilled person having the benefit of the present disclosure, that a sensor arrangement as shown in FIG. 1(a) but rotated over 90° in its entirety, is capable of measuring a magnetic field gradient dBzdy, and that a sensor arrangement as shown in FIG. 2 but rotated over 90° in its entirety, is capable of measuring a magnetic field gradient dBydy, and that a sensor arrangement as shown in FIG. 3 but rotated over 90° in its entirety, is capable of measuring a magnetic field gradient dBxdy.

It is also possible to combine any of these rotated arrangements mutually, or with any of the sensor arrangements shown in FIG. 1(a), or FIG. 2 or FIG. 3. One such combination will be explained next.

Each of the first magnetic sensor and the second magnetic sensor can comprise a single magnetic sensing element (e.g. a Hall sensing element) providing said sensor signal (as illustrated in Figs. 1 to 3). Alternatively, the first magnetic and/or the second magnetic sensor of the above-described sensor arrangements can comprise a plurality of magnetic sensing elements (e.g. Hall sensing elements) providing a set of sensor signals, optionally connected in parallel or in series.

In a particular embodiment (not illustrated), one of the first magnetic and the second magnetic sensor comprises a couple of identical and adjacent-located magnetic sensing elements (e.g. Hall sensing elements) providing a set of sensor signals being similar one to the other. The processing circuit can thus be configured to determine the difference based on the (single) sensor signal and one of the set of sensor signals, and to determine the correction term based on the (single) sensor signal and on the other signal of the set.

In another particular embodiment (not illustrated), each of the first magnetic and the second magnetic sensor comprises a couple of identical and adjacent-located magnetic sensing elements (e.g. Hall sensing elements) providing a set of (similar) sensor signals. In such embodiment, the processing circuit is configured to determine said difference based on one of each set of sensor signals and to determine the correction term based on the other one of each set of sensor signals.

In a particular embodiment (not illustrated), the magnetic sensor device further comprising a common mode magnetic sensor having at least a magnetic sensing element (e.g. Hall sensing element) and being arranged and located on a predefined location with respect to the locations of the first and second location so as to provide a common mode sensor signal (or a set of sensor signals) that is indicative (e.g. approximating up to a corresponding) a combination of the first and the second sensor signal (or of the first and second set of sensor signals respectively) being a portion of the predefined function. The processing circuit can thus be configured to determine the correction term in accordance to the predefined function using the common mode sensor signal (the common mode set of sensor signals respectively) as equivalent of such combination.

For example, the device can comprise a common mode magnetic sensor configured to sense a common mode magnetic field component being common to the first and the second sensor so as to provide a common mode signal (s12) substantially representing a combination (i.e. a sum or a difference depending on the relative orientation of the first and the second sensor) of the first and second sensor signal that can be used to calculate the correcting term. Considering the arrangement illustrated in Fig.1, the common mode magnetic sensor can be arranged and located - for example- substantially in the middle of the first and the second magnetic sensor for sensing a common component of the magnetic field, such as a common mode vertical or horizontal component. Eventually, the positions of the first and second magnetic sensor can correspond to peripheries (e.g. edges of) an integrated magnetic concentrator element (e.g. a IMC disk). In such exemplary embodiments, the processing circuit can be advantageously configured to determine a correction term using the common mode sensor signal as input of the predefined function instead of such combination of first and the second sensor signal, e.g. determining the correction value CORR12=w1*(s1+s2) by directly multiplying the coefficient w1 with the common mode sensor signal s12 (i.e. CORR12=w1*s12).

Each of the above-described sensor arrangement, notably illustrated in FIG. 1 to FIG. 3, can be (part of), or can be configured as, a position sensor device, current sensor device, or a magnetoelastic sensor device, wherein the processing circuit or another processing circuit is configured for determining a linear or an angular position of a magnetic source, an electrical current passing through a conductor, or a mechanical stress applied on a material based on the accurate determined gradient G1 as above described.

**FIG. 4(a)** shows an illustrative example of a position sensor system comprising a two-pole magnet 411 and a magnetic sensor device 410. The magnet 411 is rotatable about an axis A. The sensor device 410 is located in a so called "on-axis position". The sensor device 410 comprises a sensor arrangement 400, shown in **FIG. 4(b),** comprising four horizontal Hall elements (without IMC), located on a virtual circle or a virtual ellipse, angularly spaced by multiples of 90°.

The Hall elements H1 and H2 form a first pair from which a first magnetic field gradient dBzdx can be derived as described above in FIG. 1(a). The Hall elements H3 and H4 form a second pair from which a second magnetic field gradient dBzdy can be derived. The second pair of Hall elements can be seen as a 90° rotated version of the first pair of Hall elements. The sensor device may also comprise a temperature sensor which is preferably located inside said virtual circle, or four temperature sensors (not shown), each in the vicinity of a respective magnetic sensor (e.g. at a distance smaller than 35%*dx).

The angular position θ of the magnet 411 can then be determined in a manner which is highly insensitive to an external disturbance field, based on the two gradient signals dBzdx and dBzdy, without having to match the magnetic sensitivities of any of these four horizontal Hall elements to each other. In other words, the magnetic sensitivities of H1, H2, H3 and H4 can be four different values, and in practice they will somewhat deviate, even if exactly the same layout symbols are used.

As described above, the first gradient dBzdx can be determined in accordance with the formula:

$$dBzdx = (h2-h1)+f41(h1,h2) \qquad\qquad [8]$$

wherein h1,h2 is the first and second sensor signal, and f41() is a predefined function, which can be determined during a calibration procedure, e.g. as a polynomial expression.

In case the function f41 is approximated by a scaled sum, the first gradient can be determined in accordance with the formula:

$$dBzdx = (h2-h1)+w1*(h2+h1) \qquad [9]$$

wherein w1 can be determined during a calibration procedure, e.g. by applying a constant magnetic field, and by measuring or determining (h2-h1) and by measuring or determining (h2+h1), and by setting w1 equal to (h1-h2)/(h1+h2). This calibration procedure may be performed at a single temperature, or at multiple temperatures, and the one or more values of w1 thus determined are preferably stored in a non-volatile memory.

Likewise, the second gradient dBzdy can be determined in accordance with the formula:

$$dBzdy = (h4-h3)+f42(h3,h4) \qquad [10]$$

wherein h3,h4 is a third and a fourth sensor signal, and f42() is a predefined function, which can be determined during a calibration procedure, e.g. as a polynomial expression.

In case the function f42 is approximated by a scaled sum, the second gradient can be determined in accordance with the formula:

$$dBzdy = (h4-h3)+w2*(h4+h3) \qquad [11]$$

wherein w2 can also be determined during said calibration procedure, e.g. by measuring or determining (h4-h3), and by measuring or determining (h4+h3), and by setting w2 equal to (h3-h4)/(h3+h4), and preferably storing the value of w2 also in said non-volatile memory.

In a variant, the sensor arrangement further comprises a temperature T, and the gradients dBzdx and dBzdy are determined in accordance with the formulas:

$$dBzdx = (h2-h1)+w1(T)*(h2+h1) \qquad [12]$$

$$dBzdy = (h4-h3)+w2(T)*(h4+h3) \qquad [13]$$

wherein w1(T) is a first temperature dependent scaling factor or a first scaling function, and w2(T) is a second temperature dependent scaling factor or a second scaling function, which can be determined during said calibration procedure at multiple temperatures, and the values of w1(T) and w2(T) can be stored in said non-volatile memory.

In another variant, the sensor arrangement further comprises four temperature sensors (T1 near H1, T2 near H2, T3 near H3 and T4 near H4), and the gradients dBzdx and dBzdy are determined in accordance with the formulas:

$$dBzdx = (h2-h1)+w1(T1)*h1 + w1(T2)*h2 \qquad [14]$$

$$dBzdy = (h4-h3)+w2(T3)*h3 + w2(T4)*h4 \qquad [15]$$

These formulas may be particularly useful if the four magnetic sensors are implemented on separate sensor substrates incorporated in a WLP package for example, because their temperatures may be quite different.

During actual use of the sensor device, the angular position can then be determined based on dBzdx and dBzdy, e.g. based on a ratio of dBzdx and dBzdy, e.g. in accordance with the formula:

$$\theta = atan2(K4*dBzdx, dBzdy) \qquad [16]$$

where K4 is a predefined scaling factor, or in accordance with the formula:

$$\theta = atan2(K4(T)*dBzdx, dBzdy) \qquad [17]$$

where K4 or K4(T) is a predefined scaling factor or scaling function, which can be determined during said calibration procedure using known methods, e.g. by mounting and rotating the sensor device on the axis of a two-pole magnet, and by finding a maximum value of dBzdx (max_dBzdx) and a maximum value of dBzdy (max_dBzdy), and by assigning the value max_dBzdy/max_dBzdx to K4. The value of K4 is typically different from 1.000, because the magnetic sensitivities of the four magnetic sensor elements are typically different from each other. The value of K4 may e.g. be a value in the range from 0.90 to 0.99, or a value in the range from 0.900 to 0.995, or a value in the range from 1.01 to 1.10, or a value in the range from 1.005 to 1.100. The value of K4 may be determined for a single temperature, or for multiple temperatures, and this one or more value of K4 may also be stored in said non-volatile memory. During actual use of the device, the one or more values of w1, w2, K4 can be obtained from said non-volatile memory, and can optionally be interpolated based on one or more measured temperature.

**FIG. 4(c)** shows a schematic block diagram of an illustrative example of a circuit that can be used for biasing and read-out of the sensor arrangement of FIG. 4(b), and for determining at least one gradient. This circuit can be regarded as a variant of the circuit of FIG. 1(b), and everything mentioned above, is also applicable here, mutatis mutandis, for example: In the example shown in FIG. 4(c), four current sources are used for biasing the horizontal Hall elements, but that is not absolutely required, and it is also possible to bias the Hall elements using only two current sources, or using only one current source. It is also possible to bias the four Hall elements using one or more voltage sources (not shown) instead of current sources. In an embodiment, multiple discrete biasing sources are used which are not trimmed and are not adaptable. If multiple current sources are used, preferably the sources have identical layout symbols. In an embodiment, I1 and I3 are independent current sources, and I2 is a current mirror of I1, and I4 is a current mirror of I3.

In the example shown in FIG. 4(c), four amplifiers are used to amplify the signals obtained from the Hall elements, but that is not absolutely required, and it is also possible to use only two or only one amplifier in a time-multiplexed manner. If multiple discrete amplifiers are used, they are preferably configured to amplify by substantially the same amplifier gain.

In the example shown in FIG. 4(c) it is suggested that each of the sensor signals h1, h2, h3, h4 is first amplified to yield A_h1, A_h2, A_h3, A_h4, and is subsequently digitized, but the present invention is not limited hereto, and it is also possible to determine the difference signal and/or the sum signal in the analog domain, and to digitize that analog difference signal and/or the analog sum signal. This may improve the signal-to-noise ratio (SNR) which may further improve the accuracy of the gradient.

**FIG. 5** shows a flow-chart of a method 500 of determining a magnetic field gradient. This method can e.g. be used in combination with any of the circuits illustrated in FIG. 1(a) to FIG. 4(b). The method comprises the following steps:

a) providing in step 501 a first sensor signal (e.g. FIG. 1: h1, FIG. 2 and FIG. 3: v1, FIG. 4 first gradient: h1, FIG. 4 second gradient: h3) or a first set of sensor signals (e.g. FIG. 7: h1 and h2) by a first magnetic sensor (e.g. FIG. 1 or FIG. 4: a horizontal Hall element, FIG. 2 or FIG. 3: a vertical Hall element, FIG. 7: an IMC and 2 horizontal Hall elements) located at a first sensor location;

b) providing in step 502 a second sensor signal e.g. FIG. 1: h2, FIG. 2 and FIG. 3: v2, FIG. 4 first gradient: h2, FIG. 4 second gradient: h4) by a second magnetic sensor located at a second sensor location spaced from the first sensor location;

c) optionally measuring or determining or estimating in step 503 one or more temperatures (T, T1, T2), e.g. by measuring or estimating a single temperature (T) of a substrate comprising the first and second magnetic sensor, or by measuring or estimating a first temperature (T1) of the first sensor and a second temperature (T2) of the second sensor;

d) determining in step 504 a difference (DIFF12) between the first and the second sensor signal, or between a first combined signal derived from the first set of sensor signals and a second combined signal derived from the second set of sensor signals, e.g. in accordance with the formula: DIFF12 = (h1-h2) in FIG. 1, or in accordance with the formula: DIFF12 = (v1-v2) in FIG. 2 or FIG. 3, or in accordance with the formula: DIFF12 = (Bx2-Bx1) = ((h4-h3)-(h2-h1)) for the first gradient dBxdx of FIG. 7, or in accordance with the formula: DIFF12 = (Bz1-Bz2) =((h4+h3)-(h2+h1)) for the second gradient dBzdx of FIG. 7.

e) determining in step 505 a correction term (CORR12) of the first and the second sensor signal (s1,s2) or of the first combined signal and the second combined signal, e.g. in accordance with one of the following formulas:

$$CORR12 = f(s1, s2) \qquad [18],$$

e.g.

$$CORR12 = w*(s1+s2) \qquad [19],$$

e.g.

$$CORR12 = w(T)*(s1+s2) \qquad [20],$$

e.g.

$$CORR12 = w(T1)*s1 + w(T2)*s2 \qquad [21]$$

where "w" is a predefined scaling factor, or a temperature-dependent scaling function, which can be determined during a calibration procedure e.g. by a applying a constant magnetic field at two or more different temperatures, and for each temperature, determining the value of w as explained above (as a ratio of a difference over a sum), and storing said value in a non-volatile memory. During actual use of the device, the values stored in NV-memory can be interpolated.

The step of determining the correction term (CORR12) can comprise a step of collecting or determining one or more temperature(s) of one or more portions of the magnetic sensor device according to the predefined function having one or more coefficients dependant on the temperature. Alternatively or complementarily, the step of determining the correction term (CORR12) can comprises a step of collecting or determining one or more mechanical stresses affecting one or more portions of the magnetic sensor device (and/or a differential mechanical stress between two or more portions of the magnetic sensor device) according to the predefined function when one or more coefficients are determined based on (as function of) mechanical stress.

f) determining a gradient (G1) as a value proportional to a combination (e.g. a sum or difference) of said difference (DIFF12) and said correction term (CORR12), e.g. in accordance with the formula: G1=DIFF12 + CORR12;

The first magnetic sensor may have at least one magnetic sensor element with a first magnetic sensitivity (e.g. S1). The second magnetic sensor may have at least one magnetic sensor element with a second magnetic sensitivity (e.g. S2) different from the first sensitivity, e.g. at least 1.0 % different.

It is noted that formula [21] may be particularly useful for a sensor device implemented in a WLP-package comprising a plurality of semiconductor dies, e.g. a first semiconductor die in the form of a CMOS circuit comprising at least biasing and readout circuitry, a second semiconductor die (e.g. in the form of a Ga-As substrate) comprising a first magnetic sensor and optionally a first temperature sensor, and a third semiconductor die (e.g. in the form of a Ga-As substrate) comprising a second magnetic sensor and optionally a second temperature sensor. The second substrate (also referred to as first sensor substrate) and the third substrate (also referred to as second sensor substrate) may be connected to the first substrate (also referred to as main substrate) by means of at least one redistribution (RDL) layer. In such a device, the first and second sensor may be spaced apart over a relatively large distance, e.g. at least 5 mm, or at least 7 mm or at least 10 mm, and since they are implemented on different substrates, their temperature may be quite different.

The method 500 of determining a magnetic field gradient can be part of a method of determining a linear or an angular position of a sensor device relative to a magnetic source, an electrical current passing through a conductor, or a mechanical stress applied on a material. The method can thus integrate the above described steps a) to f) of the method 500 while comprising an additional step g) of determining: a linear or an angular position of a magnetic source, an electrical current passing through a conductor, or a mechanical stress applied on a material based on the gradient (G1) determined on step f).

**FIG. 6** shows a high-level block diagram of a sensor device 610 comprising at least two magnetic sensors M1, M2. The sensor device 610 may comprise for example two horizontal Hall elements (e.g. as illustrated in FIG. 1(a), or two vertical Hall elements (e.g. as illustrated in FIG. 2 or FIG. 3), or four horizontal Hall elements (e.g. as illustrated in FIG. 4(b), or combinations of horizontal Hall elements and vertical Hall elements, e.g. as described above.

The sensor device 610 further comprises a biasing and readout circuit 651 for biasing the magnetic sensor elements. Biasing and read-out circuits are well known in the art, are not the main focus of the present invention, and hence do not need to be described in more detail here. It suffices to say that the biasing and readout circuit may comprise for example one or more current sources or voltage sources, one or more amplifiers, one or more multiplexer, one or more analog-to-digital convertors (ADC), etc.

The sensor device 610 typically also comprises at least one temperature sensor, e.g. arranged for measuring or estimating a temperature of the magnetic sensor elements. It is noted that a single temperature sensor may be sufficient to measure one temperature for all the sensor elements, especially if all the sensor elements are embedded in a single semiconductor substrate. If the magnetic sensors are not incorporated in the same semiconductor substrate and/or if the sensor elements are located relatively far apart, e.g. at least 4.0 mm, the sensor device preferably contains a first temperature sensor for measuring a temperature of the first magnetic sensor and a second temperature sensor for measuring a temperature of the second magnetic sensor, etc.

Referring back to FIG. 6, the sensor device 610 further comprises an output circuit 653 for outputting one or more of: the signals s1, s2 provided by the magnetic sensors, or values derived therefrom, e.g. after amplification and/or digitization, e.g. a difference between two of these signals or values, a sum or a correction term of two of these signals or values, a gradient signal or value, e.g. determined in accordance with any of the formulas mentioned in FIG. 5. Optionally the sensor device may output one or more of the following: a second gradient value, a ratio of a first and a second gradient, an angle value (e.g. as illustrated in FIG. 4b).

The sensor device 610 may further comprise a processing circuit 652, e.g. a digital processing circuit, e.g. comprising a CPU or a Digital Signal Processor (DSP), e.g. configured for calculating one or more of said difference, sum, correction term, gradient, ratio, angle.

The sensor device 610 may further comprise a non-volatile memory 654, e.g. flash, which may be incorporated in the processing circuit, or may be connected to the processing circuit, and which may store one or more parameters, for example one or more of the weighting factors or scaling factors w, w1, w2, K4 described above. Of course, the non-volatile memory may also contain other information, such as e.g. a look-up table for implementing an arctangent function, etc.

In an embodiment, (see e.g. FIG. 4b) two gradients (e.g. dBzdx and dBzdy) and an angle (e.g. θ) are determined inside the sensor device 610, and one or more or all of these values are output, e.g. to an external processor 690.

Alternatively or additionally, the one or more differences, e.g. (h2-h1) and (h4-h3), and the one or more sums, e.g. (h2+h1) and (h4+h3) and/or the one or more correction terms, e.g. w1*(h2+h1), w2*(h4+h3), and/or the ratio dBzdx/dBzdy or the weighted ratio K4*dBzdx/dBzdy may be output, and the external processor 690 (if present) may calculate the gradient(s) and/or the angle.

Alternatively or additionally, the external processor (if present), may be configured for detecting an error, e.g. by also calculating one or more of the gradients and/or the angle, and by comparing them with the values received from the sensor device.

In the example of FIG. 6 only two magnetic sensors are shown, but in a variant, the sensor device comprises more than 2 magnetic sensors (e.g. four horizontal Hall elements, or two 2D magnetic pixels, each comprising a horizontal Hall element and two or four vertical Hall elements, etc.)

In another or a further variant, the external processor 690 has a non-volatile memory 691, and the sensor device 610 is communicatively connected to the external processor 690 via a bidirectional connection (not shown in FIG. 6), and the one or more scaling factors (e.g. w, w1, w2, K4) are stored in the non-volatile memory 691 of the external processor 690, and the sensor device 610 is configured for obtaining these value from the external processor 690, e.g. during start-up.

In preferred embodiments, the sensor device 610 is a single packaged semiconductor device, typically referred to as "chip package". The sensor device 610 may comprise a single semiconductor substrate, or more than one semiconductor substrate, e.g. a first semiconductor substrate comprising the first sensor group, and a second semiconductor substrate comprising the second sensor group. These semiconductor substrates may be mounted on a lead frame, and interconnected via bond wires, or may be interconnected by means of one or more RDL layers in a single WLP-package (Wafer Level Packaging), e.g. as described in EP4328607(A1) incorporated herein by reference in its entirety, in particular FIG. 1(a), FIG. 2 and FIG. 5 to FIG. 7 thereof.

FIG. 7(a) shows a semiconductor substrate 701 comprising a sensor arrangement 700 that comprises two magnetic sensor structures, spaced apart over a distance dx along a predefined axis X. Each magnetic sensor structure is a 2D magnetic pixel, and comprises: a disk shaped integrated magnetic concentrator (IMC), and two horizontal Hall elements arranged near a periphery of the IMC, angularly spaced by 180°. The disks IMC1, IMC2 may have a diameter in the range from about 150 to about 300 $\mu$m. In preferred embodiments, the distance dx may be value in the range from 1.0 mm to 3.0 mm, or in the range from 1.5 mm to 2.5 mm.

FIG. 7(b) shows a schematic block diagram of an illustrative example of a circuit that can be used for biasing and read-out of the sensor arrangement of FIG. 7(a), and for determining two gradients gradient dBxdx and dBzdx.

The Hall elements H1 and H2 are preferably biased using a first biasing voltage or a first biasing current I1. This first current may be provided by a single current source connected to both H1 and H2, or by an independent current source I1 providing a current to H1 and by a current mirror providing the same current to H2. Likewise, the Hall elements H3 and H4 are preferably biased using a second biasing signal, e.g. a second voltage or a second current I3. This second current may be provided by a single current source to both H3 and H4, or by an independent current source I3 and a current mirror I4. None of these current sources needs to be laser trimmed, or needs to be adjustable under control of a processor or a control loop. The signals obtained from the four Hall elements H1, H2, H3 and H4 are preferably amplified by at least one amplifier, e.g. by a single amplifier or by two amplifiers (e.g. operated in a time-multiplexed manner), or by four amplifiers (e.g. operated in parallel). The amplified signals A_h1, A_h2, A_h3, A_h4 can then be digitized using at least one analog-to-digital convertor (ADC).

Optionally the sensor arrangement 700 further comprises at least one temperature sensor, e.g. a single temperature sensor located in the vicinity of the first and the second magnetic sensor structure, or comprises a first temperature sensor arranged under or in the vicinity of IMC1, and a second temperature sensor arranged under or in the vicinity of IMC2. A single temperature sensor can be used, for example, if the two magnetic sensor structures are integrated on a single semiconductor substrate. Two discrete temperature sensors may be preferred if the two magnetic sensor structures are not integrated on a single semiconductor substrate.

The first magnetic sensor can measure two magnetic field components including: a magnetic field component Bx1 oriented parallel to the semiconductor substrate at the first sensor location, based on a difference between the signals obtained from H1 and H2, and a magnetic field component Bz1 oriented perpendicular to the substrate based on a sum of the signals obtained from H1 and H2, e.g. using the formulas: Bx1=(h2-h1) and Bz1=(h1+h2). Likewise the second magnetic sensor can measure two magnetic field components including: a magnetic field component Bx2 at the second sensor location based on a difference between the signals obtained from H3 and H4, and can measure a magnetic field component Bz2 at the second sensor location based on a sum of the signals obtained from H3 and H4.

According to the present invention, a gradient of Bx along the X-axis, denoted as dBxdx, can be determined in accordance with one of the following formulas:

$$dBxdx = (Bx2-Bx1)+f71(Bx1,Bx2) \qquad [22],$$

e.g.

$$dBxdx = (Bx2-Bx1)+w1*(Bx1+Bx2) \qquad [22],$$

e.g.

$$dBxdx = (Bx2-Bx1)+w1(T)*(Bx1+Bx2) \qquad [23],$$

e.g.

$$dBxdx = (Bx2-Bx1)+w1(T1)*Bx1+w1(T1)*Bx2 \qquad [24]$$

where f71() is a predefined function, w1 is a first scaling factor or a first scaling function related to the first gradient, and a gradient of Bz along the X-axis, denoted as dBzdx, can be determined in accordance with one of the following formulas:

$$dBzdx = (Bz2-Bz1)+f72(Bz1,Bz2) \qquad [25],$$

e.g.

$$dBzdx = (Bz2-Bz1)+w2*(Bz1+Bz2) \qquad [26],$$

e.g.

$$dBzdx = (Bz2-Bz1)+w2(T)*(Bz1+Bz2) \qquad [27],$$

e.g.

$$dBzdx = (Bz2-Bz1)+w2(T1)*Bz1+w2(T2)*Bz2 \qquad [28]$$

where f72() is a predefined function, w2 is a second scaling factor or a second scaling function related to the second gradient,
where w1 and w2 can be determined during a calibration procedure, e.g. while applying a constant magnetic field, optionally at multiple temperatures, and the value(s) of w1 and w2 can be written in a non-volatile memory, e.g. inside the sensor device, or external to the sensor device but connected thereto. If multiple values for w1 and w2 are determined during the calibration procedure, a suitable value for w1 and w2 may be determined during actual use of the device by interpolating the values stored in the non-volatile memory taking into account one or more measured temperature(s).

It is a major advantage of this embodiment that the gradients so determined have an improved accuracy, and have a reduced sensitivity to an external disturbance field, without having to match all the magnetic sensitivities by adjusting one or more biasing signals and/or amplifier gains.

In a variant (not shown) of FIG. 7(a) and FIG. 7(b), the circuit has a first temperature sensor arranged in the vicinity of IMC1, and a second temperature sensor arranged in the vicinity of IMC2. In this case, formulas [23] and [26] are preferably used.

In another or a further variant (not shown) of FIG. 7(a) and FIG. 7(b), H1 and H2 are not located on the X-axis, but on an axis Y1 perpendicular to X, and H3 and H4 are not located on the X-axis, but on an axis Y2 perpendicular to X. Such a sensor structure is capable of measuring two magnetic field components By1, Bz1 at the first sensor location, and two magnetic field components By2, Bz2 at the second sensor location, e.g. using the formulas: By1=(h2-h1), Bz1=(h1+h2), By2=(h4-h3), Bz2=(h3+h4). Using such a sensor arrangement, a gradient of By along the X-axis, denoted as dBydx can be determined using one of the following formulas:

$$dBydx = (By2-By1)+f73(By1, By2) \qquad [29],$$

e.g.

$$dBydx = (By2-By1)+w1*(By1+By2) \qquad [30],$$

e.g.

$$dBydx = (By2-By1)+w1(T)*(By1+By2) \qquad [31],$$

e.g.

$$dBydx = (By2-By1)+w1(T1)*By1+w1(T2)*By2 \qquad [32]$$

and a gradient of Bz along the X-axis, denoted as dBzdx, can be determined in accordance with one of the following formulas:

$$dBzdx = (Bz2-Bz1)+f74(Bz1, Bz2) \qquad [33],$$

e.g.

$$dBzdx = (Bz2-Bz1)+w2*(Bz1+Bz2) \qquad [34],$$

e.g.

$$dBzdx = (Bz2-Bz1)+w2(T)*(Bz1+Bz2) \qquad [35],$$

e.g.

$$dBzdx = (Bz2-Bz1)+w2(T1)*Bz1+w2(T2)*Bz2 \qquad [36]$$

where w1 and w2 can be determined during a calibration procedure, e.g. while applying a constant magnetic field, optionally at multiple temperatures, and the value(s) of w1 and w2 can be written in a non-volatile memory, e.g. inside the sensor device, or external to the sensor device but connected thereto.

**FIG.8(a)** shows a semiconductor substrate 801 comprising a sensor arrangement 800 that comprises two magnetic sensor structures, spaced apart over a distance dx along a predefined axis X. Each magnetic sensor structure is a 3D magnetic pixel, and comprises: a disk shaped integrated magnetic concentrator (IMC), and four horizontal Hall elements arranged near a periphery of the IMC, angularly spaced by multiples of 90°. The sensor structure 800 of FIG. 8(a) can be seen as a variant of the sensor structure 700 of FIG. 7(a) wherein each pixel has four horizontal Hall elements instead of only two.

The sensor arrangement of FIG. 8(a) allows to measure a first set of three orthogonal magnetic field components Bx1, By1, Bz1 at the first sensor location (e.g. substantially in the centre of IMC1) and to measure a second set of three orthogonal magnetic field components Bx2, By2, Bz2 at the second sensor location (e.g. substantially in the centre of IMC2).

According to the present invention, three gradients along the X-axis can then be determined for example using the following formulas:

$$dBxdx=(Bx2-Bx1)+f81(Bx1, Bx2) \qquad [37]$$

$$dBydx=(By2-By1)+f82(By1,By2) \qquad [38]$$

$$dBzdx=(Bz2-Bz1)+f83(Bz1,Bz2) \qquad [39]$$

or if the predefined functions are approximated by a scaled sum, using the following formulas:

$$dBxdx=(Bx2-Bx1)+w1*(Bx1+Bx2) \qquad [40]$$

$$dBydx=(By2-By1)+w2*(By1+By2) \qquad [41]$$

$$dBzdx=(Bz2-Bz1)+w3*(Bz1+Bz2) \qquad [42]$$

wherein w1, w2 and w3 are scaling factors that can be determined during a calibration procedure, e.g. while applying a constant magnetic field, optionally at multiple temperatures. The value(s) of w1, w2, w3 can be written in a non-volatile memory, e.g. inside the sensor device, or external to the sensor device but connected thereto. If multiple values for w1, w2, w3 are determined during the calibration procedure, a suitable value for w1, w2, w3 may be determined during actual use of the device by interpolating the values stored in the non-volatile memory taking into account the measured or estimated temperature. If a single temperature T is measured, the following set of formulas may be used:

$$dBxdx=(Bx2-Bx1)+w1(T)*(Bx1+Bx2) \qquad [43]$$

$$dBydx=(By2-By1)+w2(T)*(By1+By2) \qquad [44]$$

$$dBzdx=(Bz2-Bz1)+w3(T)*(Bz1+Bz2) \qquad [45]$$

If a first temperature T1 is measured for the first sensor, and a second temperature T2 is measured for the second sensor, the following set of formulas may be used:

$$dBxdx=(Bx2-Bx1) + w1(T1)*Bx1 + w1(T2)*Bx2 \qquad [46]$$

$$dBydx=(By2-By1) + w2(T1)*By1 + w2(T2)*By2 \qquad [47]$$

$$dBzdx=(Bz2-Bz1) + w3(T1)*Bz1 + w3(T2)*Bz2 \qquad [48]$$

**FIG. 8(b)** shows a schematic block diagram of an illustrative example of a circuit that can be used for biasing and read-out of the sensor arrangement of FIG. 8(a), and for determining said three gradients: dBxdx, dBydx, dBzdx. This block-diagram is a variant of the block-diagram of FIG. 7(b), and everything mentioned above is also applicable here, mutatis mutandis. For example:

- the sensor elements H1, H2, H3, H4 may be biased using a first current source or a first voltage source, or from a plurality of current sources and/or current mirrors; and the sensor elements H5, H6, H7, H8 maybe be biased from a second current source or a second voltage source, or from a plurality of current sources and/or current mirrors. The second current source can be independent from the first current source, and does not need to adjustable;
- the signals obtained from the Hall elements and/or from the one or more temperature sensors may be amplified by at least one amplifier, or by a plurality of amplifiers in a time-multiplexed manner, or all at once;
- one or more temperature signals may be obtained; they may be digitized by the same ADC that also digitizes the magnetic sensor signals or by another ADC, or temperature sensors with digital output may be used.

**FIG. 9** shows a flow-chart of a method of determining one or more magnetic field gradients, proposed by the present invention, e.g. as can be used in conjunction with the sensor arrangement of FIG. 7(a) or FIG. 8(a), sometimes referred to as a "dual disk arrangement" with 2D or 3D magnetic pixels.

The method 900 of FIG. 9 can be seen as a special case of the method 500 of FIG. 5, and comprises the following steps:

a) measuring in step 901 a first magnetic field component (e.g. Bx1) using a first magnetic sensor structure comprising a first set of at least two horizontal Hall elements (e.g. H1, H2 of FIG. 7a) arranged near a periphery of a first IMC (IMC1) situated at a first sensor location;

b) measuring in step 902 a second magnetic field component (e.g. Bx2) using a second magnetic sensor structure comprising a second set of at least two horizontal Hall elements (e.g. H3, H4 of FIG. 7a) arranged near a periphery of a second IMC (IMC2) situated at a second sensor location spaced from the first sensor location;

c) optionally measuring or determining or estimating in step 903 one or more temperatures of the first and second magnetic sensor, e.g. a single temperature T for both sensor structures, or a first temperature T1 for the first sensor structure and a second temperature T2 for the second sensor structure;

d) determining in step 904 a difference (e.g. DIFF12x) between the first and the second magnetic field component (Bx1,Bx2), e.g. in accordance with the formula: DIFF12x=(Bx2-Bx1); Likewise, if the sensors are capable of measuring By components, a difference DIFF12y=(By2-By1) can be determined; Likewise, if the sensors are capable of measuring Bz components, a difference DIFF12z=(Bz2-Bz1) can be determined;

e) determining a correction term (e.g. CORR12x) of the first and the second magnetic field component (e.g. Bx1, Bx2), e.g. using one of the following formulas: CORR12x=f91(Bx1,Bx2),

e.g. CORR12x=w1*(Bx1+Bx2), or CORR12x=w1(T)*(Bx1+Bx2), or CORR12x=w1(T1)*Bx1+w1(T2)*Bx2; Likewise, if the sensor structures are capable of measuring By components, a non-zero correction term CORR12y can be determined using one of the following formulas: CORR12y=f92(By1,By2),

e.g. CORR12y=w2*(By1+By2), or CORR12y=w2(T)*(By1+By2), or CORR12y=w2(T1)*By1+w2(T2)*By2; Likewise, if the sensor structures are capable of measuring Bz components, a non-zero correction term CORR12z can be determined using one of the following formulas: CORR12z=f93(Bz1,Bz2),

e.g. CORR12z=w3*(Bz1+Bz2), or CORR12z=w3(T)*(Bz1+Bz2), or CORR12z=w3(T1)*Bz1 +w3(T2)*Bz2; where w1,w2,w3 are scaling factors or scaling functions that can be determined during a calibration procedure.

f) determining in step 906 a gradient (e.g. dBxdx) as a value proportional to a combination of said difference (DIFF12x) and said correction term (CORR12x), e.g. in accordance with the formula:
dBxdx = DIFF12x + CORR12x; Likewise a gradient dBydx can be determined in accordance with the formulas dBydx = DIFF12y + CORR12y; Likewise a gradient dBzdx can be determined in accordance with the formulas dBzdx = DIFF12z + CORR12z.

The first and second set of horizontal Hall elements may have different magnetic sensitivities.

According to another aspect of the invention, the invention provides an accurate gradient determination, not only despite temperature variations, but also - alternatively or complementarily-despite stress variations over the sensor device, in a simple manner (e.g. without having to solve a set of equations).

The magnetic sensor device can - alternatively or complementarily to the temperature sensor(s)- comprise a stress measurement circuit (not illustrated) configured for determining a mechanical stress affecting a portion of the magnetic sensor device (e.g. as at, or near, one of the locations of the magnetic sensors and/or between locations of the magnetic sensors) and for providing a stress signal $\Sigma$ representing the measured mechanical stress. Alternatively or complementarily, the stree measurement circuit can be configured to determine a differential stress between two portions of the magnetic sensor device (e.g. notably a differential stress between the first and the second sensor location) and to provide a differential stress signal $\Delta\Sigma$ representing the measured differential mechanical stress.

The measured stress $\Sigma$ and/or the differential stress $\Delta\Sigma$, notably a value of such signal (e.g. a digitized amplitude), can be then acquired by the signal processing circuit so as to determine the correction term based on such stress, e.g. by determining or adjusting one of more coefficient(s) of the predefined function based on such stress signal (e.g. value).

In an embodiment, wherein the temperature is not measured, the processing circuit can be configured to determine, or to adjust, the correction term by means of the predefined function according to the provided differential stress signal.

The predefined function can be expressed as a polynomial expression of the first and second set of sensor signals (or of the first and the set of sensor signals), wherein one of more coefficients are predetermined as function of the differential stress, e.g.: $c0 + c1*s1 + c2*s2 + c3*s1^2 + c4*s2^2 + c5*s1^3 + c6*s2^3$, wherein some of the coefficients c0-c6 are dependant of the (provided) stress signal, e.g. expressible as $c(\Sigma)$ or $c(\Delta\Sigma)$.

The inventors noticed that even a simplified expression, such as a linear combination or even a scaled sum of the first and second sensor signal (or of the first and second set of sensor signals), can provide an accurate correction of the gradient for most applications, e.g.

w1($\Sigma,\Delta\Sigma$)\*s1+w2($\Sigma,\Delta\Sigma$)\*s2, w($\Sigma,\Delta\Sigma$)\*(s1+s2) respectively, wherein the coefficient(s) w($\Sigma,\Delta\Sigma$) is, respectively w1($\Sigma,\Delta\Sigma$) and w2($\Sigma,\Delta\Sigma$) are, predetermined coefficient as function of the stress and/or of the differential stress.

In another embodiment, wherein the temperature is measured according to one of the above-described arrangements, the processing circuit can be configured to determine, or to adjust, the correction term by means of the predefined function according not only to (measured) temperature, but also according to (measured) stress and/or differential stress.

The predefined function can be expressed as a polynomial expression of the first and second set of sensor signals (or of the first and the set of sensor signals), wherein one of more coefficients are predetermined as function of the temperature and/or of stress and/or differential stress, e.g.: $c0 + c1*s1 + c2*s2 + c3*s1^2 + c4*s2^2 + c5*s1^3 + c6*s2^3$, wherein a first set of the coefficients c0-c6 is dependant of the temperature e.g. expressible as c(T), a second set of the coefficients c0-c6 is dependant of the stress/differential stress, e.g. expressible as c($\Sigma,\Delta\Sigma$), and a third set of the coefficients c0-c6 is dependant of both the temperature an of the stress/differential stress, e.g. expressible as c(T, $\Sigma,\Delta\Sigma$).

The inventors noticed that even a simplified expression, such as a linear combination or even a scaled sum of the first and second sensor signal (or of the first and second set of sensor signals), can provide an accurate correction of the gradient for most current applications, e.g.

w1(T1,$\Sigma$1,$\Delta\Sigma$)\*s1+w2(T2,$\Sigma$2,$\Delta\Sigma$)\*s2, wherein the coefficient w1(T1,$\Sigma$1, $\Delta\Sigma$) depends on a first temperature and/or on a first stress and/or on differential mechanical stress, and wherein the coefficient w2(T2,$\Sigma$2, $\Delta\Sigma$) depends on a second temperature and/or on a second stress and/or on differential mechanical stress;

w(T,$\Sigma,\Delta\Sigma$)\*(s1+s2), wherein w(T,$\Sigma,\Delta\Sigma$) depend on a (common) temperature and/or on a (common) mechanical stress and/or on a differential mechanical stress.

In a variant of the embodiment, the differential stress signal is digitized by the ADC of the readout circuit so as the DSP of the processing circuit can determine the correction term in the digital domain. In another variant of the embodiment, a differential stress measurements circuit is configured to provide a digital signal that could be directly provided to the DSP. In another variant, the processing circuit is configured to determine the correction term, eventually the difference between the sensors signals, eventually even the combination of the gradient and the correction term, in the analog domain.

Similarly to temperature-based determination of correction term, it is possible to determine the value of such coefficient(s) (e.g. the scaling factor "w($\Sigma,\Delta\Sigma$)" or "w(T, $\Sigma$, $\Delta\Sigma$)") for a set of mechanical stresses and/or different differential mechanical stresses, eventually in combination with a set of different temperatures, during a calibration procedure. The set can, for example, comprise at least two different stresses, or for three different stresses, wherein such set of calibrated coefficients can be then stored in the non-volatile memory. During actual use of the sensor device, a suitable value for the scaling factor "w" can then be determined by measuring a differential mechanical stress of the sensor device, and by interpolating the scaling factors stored in the non-volatile memory.

<u>REFERENCE NUMBERS</u>

| | |
|---|---|
| -00 | sensor arrangement |
| -01 | semiconductor substrate |
| -10 | sensor device |
| -11 | permanent magnet |
| -12 | non-volatile memory (e.g. flash) |
| -51 | biasing and readout circuit |
| -52 | processing circuit |
| -53 | output circuit |
| -54 | non-volatile memory |
| -90 | external processor |
| -91 | non-volatile memory of external processor |
| H1 | first horizontal Hall element, etc. |
| h1 | sensor signal obtained from horizontal Hall element H1 |
| V1 | first vertical Hall element |
| v1 | sensor signal obtained from vertical Hall element V1 |
| T | temperature sensor, or temperature |
| t | analog temperature |
| dx | distance between two sensor positions (e.g. a value in the range from 500 to 3000 $\mu$m) |
| w1, w2, etc. | weight factor or scaling factor |
| w1(T), w2(T),etc. | weight factor or scaling factor as a function of temperature |

**Claims**

1. A magnetic sensor device for measuring a gradient (G1) of a magnetic field generated by a magnetic source, comprising:

   - a first magnetic sensor located on a first sensor location, and configured for providing a first sensor signal (s1) or a first set of sensor signals;
   - a second magnetic sensor located on a second sensor location, spaced from the first sensor location, and configured for providing a second sensor signal (s2) or a second set of sensor signals;
   - a processing circuit for determining a gradient based on the first and second sensor signal (s1 s2), or based on the first and second set of sensor signals;

   wherein

   - the processing circuit is configured for determining a difference (DIFF12) between the first and the second sensor signal (s1, s2), or for determining a difference between a first combined signal derived from the first set of sensor signals and a second combined signal derived from the second set of sensor signals;
   - and the processing circuit is configured for determining a correction term (CORR12) as a predefined function of the first and second sensor signal (s1, s2) or of the first and second set of sensor signals;
   - and the processing circuit is configured for determining said gradient (G1) as a value proportional to a combination of said difference (DIFF12) and said correction term (CORR12).

2. A magnetic sensor device according to claim 1,

   wherein the predefined function is a polynomial expression of the first and second sensor signal (s1, s2) or a polynomial expression of the first and second set of sensor signals;
   or wherein the predefined function is a linear combination of the first and second sensor signal (s1, s2) or a linear combination of the first and second set of sensor signals;
   or wherein the predefined function is a scaled sum of the first and second sensor signal (s1, s2) or a scaled sum of the first and second set of sensor signals.

3. A magnetic sensor device according to any of the previous claims,

   wherein the correction term (CORR12) is determined in accordance with the following formula: CORR12=w1* (s1+s2), wherein w1 is a scaling factor different from zero;
   or wherein the correction term (CORR12) is determined in accordance with the following formula: CORR12= (w1*s1)+(w2*s2), wherein w1 is a first scaling factor different from zero, and w2 is a second scaling factor different from zero.

4. A magnetic sensor device according to any of the previous claims,

   further comprising a common mode magnetic sensor configured and located on a predefined location with respect to said first and second location so as to provide a common mode sensor signal or a common mode set of sensor signals being indicative of a combination of the first and the second sensor signal (s1, s2) or of the first and second set of sensor signals; and
   wherein the processing circuit is configured for determining said correction term using said common mode sensor signal or a common mode set of sensor signals according to the predefined function;
   preferably said combination being a linear combination of the first and second sensor signal (s1, s2) or a linear combination of the first and second set of sensor signals;
   more preferably said combination being a sum of the first and second sensor signal or of the first and second set of sensor signals.

5. A magnetic sensor device according to any of the previous claims,
   further comprising a non-volatile memory storing coefficients of said predefined function.

6. A magnetic sensor device according to any of the claims 1 to 5,

   - further comprising a semiconductor substrate comprising said first magnetic sensor and said second magnetic sensor and a temperature sensor for measuring a temperature (T) of the semiconductor substrate;
- and wherein the processing circuit is configured for determining at least one coefficient of said predefined function according to a temperature provided by said temperature sensor; preferably the processing circuit being configured for determining the correction term (CORR12) in accordance with the following formula: CORR12=w(T)*(s1 + s2), wherein w(T) is a scaling function of temperature, different from zero.

7. A magnetic sensor device according to any of the claims 1 to 5,

- further comprising a first temperature sensor for measuring a first temperature (T1) of the first magnetic sensor;
- and further comprising a second temperature sensor for measuring a second temperature (T2) of the second magnetic sensor;
- and wherein the processing circuit is configured for determining the correction term (CORR12) in accordance with the following formula: CORR12=w(T1)*s1 + w(T2)*s2, wherein w(.) is a first scaling function of temperature, different from zero, T1 is the first temperature, and T2 is the second temperature.

8. A magnetic sensor device according to any of the claims 1 to 7,

further comprising a stress measurement circuit configured for determining a mechanical stress actin on a portion of the magnetic sensor device, preferably between and/or near the first sensor location and/or the second sensor location, and for providing a differential stress signal indicating determined mechanical stress;
wherein the processing circuit is configured for determining the correction term (CORR12) based on a stress value of the stress signal provided by the stress measurement circuit; preferentially the processing circuit being configured to determine and/or adjusting at least a coefficient of the predefined function based on said stress value.

9. A magnetic sensor device according to any of the claims 1 to 8,

wherein the first magnetic sensor is or comprises a first horizontal Hall element (H1),
and the second magnetic sensor is or comprises a second horizontal Hall element (H2).

10. A magnetic sensor device according to any of the claims 1 to 8,

wherein the first magnetic sensor is or comprises a first vertical Hall element (V1),
and the second magnetic sensor is or comprises a second vertical Hall element (V2).

11. A magnetic sensor device according to any of the claims 1 to 8,

wherein the first magnetic sensor comprises a first integrated magnetic concentrator disk (IMC1) and two horizontal Hall elements (H1, H2) arranged near a periphery of the first integrated magnetic concentrator disk, and wherein the second magnetic sensor comprises a second integrated magnetic concentrator disk (IMC2) and two horizontal Hall elements (H3, H4) arranged near a periphery of the second integrated magnetic concentrator disk.

12. A magnetic sensor device according to any of the previous claims,

further comprising a third magnetic sensor located at a third sensor location, and configured for providing a third sensor signal (s3) or a third set of sensor signals;
and further comprising a fourth magnetic sensor located at a fourth sensor location spaced from the third sensor location, and configured for providing a fourth sensor signal (s4) or a fourth set of sensor signals;
and wherein the processing circuit is further configured for determining a second difference (DIFF34) between the third and the fourth sensor signal (s3, s4);
and for determining a second gradient (G2) as a value proportional to a second combination of said second difference (DIFF34) and a second correction term (CORR34) of the third and the fourth sensor signal (s3, s4).

13. A magnetic sensor device according to claim 12, with one or more of the following features:

wherein the first, second, third and fourth magnetic sensor are horizontal Hall elements;
wherein the first, second, third and fourth magnetic sensor are located on a virtual circle,

wherein the first and second magnetic sensor are located diametrically opposite each other,
wherein the third and fourth magnetic sensor are located diametrically opposite each other,
wherein the first and third magnetic sensor are angularly spaced by 90°.

14. A magnetic sensor device according to claim 12,

wherein the first and second magnetic sensor are horizontal Hall elements, located on a predefined axis (X), spaced apart by a predefined distance (dx);
wherein the third and fourth magnetic sensor are vertical Hall elements, located on said axis (X), spaced apart by said predefined distance (dx);
wherein the first and third magnetic sensor are located adjacent each other;
wherein the second and fourth magnetic sensor are located adjacent each other.

15. A magnetic sensor device according to any of the previous claims,

- wherein the processing circuit or another processing circuit is configured for determining a linear or an angular position of a magnetic source, an electrical current passing through a conductor, or a mechanical stress applied on a material based on said gradient (G1), preferably a linear or an angular position of a magnet based on a ratio of the first gradient (G1) and the second gradient (G2).

16. A method (500) of determining a gradient (G1) of a magnetic field generated by a magnetic source, the method comprising the steps of:

a) providing (501) a first sensor signal (s1) or a first set of sensor signals by a first magnetic sensor located at a first sensor location;
b) providing (502) a second sensor signal (s2) or a second set of sensor signals by a second magnetic sensor located at a second sensor location located at a second sensor location spaced from the first sensor location;
d) determining (504) a difference (DIFF12) between the first and the second sensor signal (s1,s2) or between a first combined signal derived from the first set of sensor signals and a second combined signal derived from the second set of sensor signals;
e) determining (505) a correction term (CORR12) as a predefined function of the first and the second sensor signal (s1, s2), or as a predefined function of the first combined signal and the second combined signal;
f) determining said gradient (G1) as a value proportional to a combination of said difference (DIFF12) and said correction term (CORR12).

17. A method of determining a linear or an angular position of a sensor device relative to a magnetic source, wherein the sensor device comprises a first, second, third and fourth magnetic sensor having four different magnetic sensitivities, and wherein the magnetic source generates a magnetic field,
the method comprising the steps of:

a) determining a first gradient (G1) by applying the method of claim 16 based on sensor signals from the first and second magnetic sensor;
b) determining a second gradient (G2) by applying the method of claim 16 based on sensor signals from the third and the fourth magnetic sensor;
c) determining a linear or an angular position based on a ratio of the first gradient (G1) and the second gradient (G2).

Bz1=h1
Bz2=h2

if magnetic sensitivity S1 = magnetic sensitivity S2,
then gradient dBzdx = (h2-h1)

if magnetic sensitivity S1 ≠ magnetic sensitivity S2,
    gradient dBzdx = (h2-h1) + f1(h1,h2)
e.g. gradient dBzdx = (h2-h1) + w*(h2+h1)
e.g. gradient dBzdx = (h2-h1) + w(T)*(h2+h1)
e.g. gradient dBzdx = (h2-h1) + w(T1)*h1 + w(T2)*h2

# FIG. 1(a)

FIG. 1(b)

FIG. 1(c)

201

Y

Z  X

T1     T     T2

V1 →          V2 →     X

dx

x1              x2

200

Bx1=v1; Bx2=v2
     gradient dBxdx = (v2-v1) + f2(v1,v2)
e.g. gradient dBxdx = (v2-v1) + w*(v2+v1)
e.g. gradient dBxdx = (v2-v1) + w(T)*(v2+v1)
e.g. gradient dBxdx = (v2-v1) + w(T1)*v1 + w(T2)*v2

# FIG. 2

301

Y

Z  X

T1 ↑     T     ↑ T2

V1          V2     X

dx

x1              x2

300

By1=v1; By2=v2
     gradient dBydx = (v2-v1) + f3(v1,v2)
e.g. gradient dBydx = (v2-v1) + w*(v2+v1)
e.g. gradient dBydx = (v2-v1) + w(T)*(v2+v1)
e.g. gradient dBydx = (v2-v1) + w(T1)*v1 + w(T2)*v2

# FIG. 3

**FIG. 4(a)**

400

401

Bz1=h1       gradient dBzdx = (h2-h1)+f41(h1,h2)
Bz2=h3   e.g. gradient dBzdx = (h2-h1)+w1*(h2+h1)
Bz3=h3       gradient dBzdy = (h4-h3)+f42(h3,h4)
Bz4=h4   e.g. gradient dBzdy = (h4-h3)+w2*(h4+h3)
             θ = atan2(K4*dBzdx, dBzdy)

**FIG. 4(b)**

# FIG. 4(c)

a) providing a first sensor signal (s1) or a first set of sensor signals by a first magnetic sensor located at a first sensor location;
(the first magnetic sensor may have at least one magnetic sensor element with a first magnetic sensitivity S1)

501

b) providing a second sensor signal (s2) or a second set of sensor signals by a second magnetic sensor located at a second sensor location spaced from the first sensor location;
(the second magnetic sensor may have at least one magnetic sensor element with a second magnetic sensitivity S2 different from S1)

502

c) optionally measuring or determining or estimating one or more temperatures (T, T1, T2) of the first and second magnetic sensor;

503

d) determining a difference (DIFF12) between the first and the second sensor signal (s1,s2) or between a first combined signal derived from the first set of sensor signals and a second combined signal derived from the second set of sensor signals, e.g. in accordance with the formula: DIFF12 = (s1-s2);

504

e) determining a correction term (CORR12) as a predefined function of the first and the second sensor signal (s1,s2) or of the first combined signal and the second combined signal,
e.g. in accordance with the formulas: CORR12=f(s1,s2),
e.g. CORR12=w*(s1+s2), e.g. CORR12=w(T)*(s1+s2),
e.g. CORR12=w(T1)*s1+w(T2)*s2, where w is a scaling factor or function, that can be determined during a calibration procedure;

505

f) determining a gradient (G1) as a value proportional to a combination of said difference (DIFF12) and said correction term (CORR12),
e.g. in accordance with the formula: G1=DIFF12 + CORR12

506

500

**FIG. 5**

preferably: packaged device

601

M1 — s1 → Biasing and Readout Circuit | (opt.) Processing Circuit 652 | Output Circuit

M2 — s2 →

T — t →

651

NV-MEM 654

653

OUT

610

690 external processor (e.g. ECU)

NV-MEM

691

# FIG. 6

Bx1=(h2-h1)                    Bx2=(h4-h3)
Bz1=(h1+h2)                    Bz2=(h3+h4)

700

gradient dBxdx = (Bx2-Bx1) + f71(Bx1,Bx2)
gradient dBzdx = (Bz2-Bz1) + f72(Bz1,Bz2)
e.g.
gradient dBxdx = (Bx2-Bx1) + w1*(Bx1+Bx2)
gradient dBzdx = (Bz2-Bz1) + w2*(Bz1+Bz2)
or
gradient dBxdx = (Bx2-Bx1) + w1(T)*(Bx1+Bx2)
gradient dBzdx = (Bz2-Bz1) + w2(T)*(Bz1+Bz2)
or
gradient dBxdx = (Bx2-Bx1) + w1(T1)*Bx1 + w1(T2)*Bx2
gradient dBzdx = (Bz2-Bz1) + w2(T1)*Bz1 + w2(T2)*Bz2

# FIG. 7(a)

**FIG. 7(b)**

801

800

Bx1=(h1-h2)          Bx2=(h6-h5)
By1=(h3-h4)          By2=(h7-h8)
Bz1=(h1+h2) or       Bz2=(h5+h6) or
    (h3+h4) or           (h7+h8) or
    (h1+h2+h3+h4)        (h5+h6+h7+h8)

gradient dBxdx = (Bx2-Bx1) + f81(Bx1,Bx2)
e.g. gradient dBxdx = (Bx2-Bx1) + w1*(Bx1+Bx2)
e.g. gradient dBxdx = (Bx2-Bx1) + w1(T)*(Bx1+Bx2)
e.g. gradient dBxdx = (Bx2-Bx1) + w1(T1)*Bx1 + w1(T2)*Bx2

gradient dBydx = (By2-By1) + f82(By1,By2)
e.g. gradient dBydx = (By2-By1) + w2*(By1+By2)
e.g. gradient dBydx = (By2-By1) + w2(T)*(By1+By2)
e.g. gradient dBydx = (By2-By1) + w2(T1)*By1 + w2(T2)*By2

gradient dBzdx = (Bz2-Bz1) + f83(Bz1,Bz2)
e.g. gradient dBzdx = (Bz2-Bz1) + w3*(Bz1+Bz2)
e.g. gradient dBzdx = (Bz2-Bz1) + w3(T)*(Bz1+Bz2)
e.g. gradient dBzdx = (Bz2-Bz1) + w3(T1)*Bz1 + w3(T2)*Bz2

# FIG. 8(a)

**FIG. 8(b)**

a) measuring a first magnetic field component (e.g. Bx1) using a first magnetic sensor structure comprising a first set of at least two horizontal Hall elements arranged near a periphery of a first IMC (IMC1) situated at a first sensor location; — 901

b) measuring a second magnetic field component (e.g. Bx2) using a second magnetic sensor structure comprising a second set of at least two horizontal Hall elements arranged near a periphery of a second IMC (IMC2) situated at a second sensor location spaced from the first sensor location;
(the first and second set of horizontal Hall elements may have different magnetic sensitivities) — 902

c) optionally measuring or determining or estimating one or more temperatures (T, T1, T2) of the first and second magnetic sensor; — 903

d) determining a difference (e.g. DIFF12x) between the first and the second magnetic field component (e.g. Bx1,Bx2),
e.g. in accordance with the formula: DIFF12x=(Bx2-Bx1);
Likewise DIFF12y=(By2-By1); DIFF12z=(Bz2-Bz1); — 904

e) determining a correction term (e.g. CORR12x) of the first and the second magnetic field component (e.g. Bx1, Bx2), e.g. in accordance with the formula:
CORR12x=f91(Bx1,Bx2), e.g. CORR12x =w1*(Bx1+Bx2),
e.g. CORR12x=w1(T)*(Bx1+Bx2), e.g. CORR12x=w1(T1)*Bx1+w1(T2)*Bx2;
Likewise, CORR12y=f92(By1,By2), e.g. CORR12y=w2*(By1+By2),
e.g. CORR12y=w2(T)*(By1+By2), e.g. CORR12y=w2(T1)*By1+w2(T2)*By2;
Likewise CORR12z=f93(Bz1,Bz2), e.g. CORR12z=w3*(Bz1+Bz2),
e.g. CORR12z=w3(T)*(Bz1+Bz2), e.g. CORR12z=w3(T1)*Bz1+w3(T2)*Bz2;
where w1,w2,w3 are scaling factors or scaling functions determined during a calibration procedure; — 905

f) determining a gradient (e.g. dBxdx) as a value proportional to a combination of said difference (DIFF12x) and said correction term (CORR12x),
e.g. in accordance with the formula: dBxdx = DIFF12x + CORR12x
Likewise dBydx = DIFF12y + CORR12y;
Likewise dBzdx = DIFF12z + CORR12z; — 906

900

# FIG. 9

Europäisches
Patentamt
European
Patent Office
Office européen
des brevets

# EUROPEAN SEARCH REPORT

**Application Number**

EP 24 22 0975

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/276071 A1 (ROMERO HERNÁN D [AR]) 1 September 2022 (2022-09-01) | 1-6,9,16 | INV. G01R33/00 |
| Y | * figures 1, 4 * <br> * paragraph [0004] * <br> * paragraph [0022] * <br> * paragraph [0035] - paragraph [0037] * <br> * paragraph [0041] * <br> * paragraph [0061] * <br> * paragraph [0066] - paragraph [0072] * <br> ----- | 7,8, 10-15,17 | G01R33/022 G01R33/07 |
| X | US 2019/312579 A1 (ROMERO HERNÁN D [AR]) 10 October 2019 (2019-10-10) | 1,2,4,5, 9,16 | |
| Y | * figure 8 * <br> * paragraph [0024] * <br> * paragraph [0032] - paragraph [0036] * <br> * paragraph [0047] - paragraph [0054] * <br> * paragraph [0065] - paragraph [0068] * <br> ----- | 7,8, 10-15,17 | |
| X | CN 117 110 954 A (UNIV BEIHANG) 24 November 2023 (2023-11-24) | 1,2,4,5, 16 | |
| Y | * figure 1 * <br> * paragraph [0002] * <br> * paragraph [0006] - paragraph [0007] * <br> * paragraph [0018] * <br> ----- | 7,8, 10-15,17 | **TECHNICAL FIELDS SEARCHED (IPC)** <br> G01R |
| Y | US 2022/018880 A1 (HOUIS SIMON [CH]) 20 January 2022 (2022-01-20) <br> * figure 13 * <br> * paragraph [0254] * <br> ----- | 7 | |
| Y | US 2024/125624 A1 (DUPRE NICOLAS [CH] ET AL) 18 April 2024 (2024-04-18) <br> * figures 4, 10, 14-19 * <br> * paragraph [0263] - paragraph [0264] * <br> * paragraph [0450] * <br> ----- | 8,10-15, 17 | |

| The present search report has been drawn up for all claims | | |
|---|---|---|
| Place of search <br> Munich | Date of completion of the search <br> 7 July 2025 | Examiner <br> Philipp, Peter |

EPO FORM 1503 03.82 (P4C01)

## ANNEX TO THE EUROPEAN SEARCH REPORT
## ON EUROPEAN PATENT APPLICATION NO.

EP 24 22 0975

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2025

| Patent document cited in search report | | Publication date | Patent family member(s) | | Publication date |
|---|---|---|---|---|---|
| US 2022276071 A1 | | 01-09-2022 | NONE | | |
| US 2019312579 A1 | | 10-10-2019 | NONE | | |
| CN 117110954 A | | 24-11-2023 | NONE | | |
| US 2022018880 A1 | | 20-01-2022 | CN | 113945747 A | 18-01-2022 |
| | | | EP | 3940396 A1 | 19-01-2022 |
| | | | US | 2022018880 A1 | 20-01-2022 |
| | | | US | 2023358789 A1 | 09-11-2023 |
| US 2024125624 A1 | | 18-04-2024 | CN | 113432517 A | 24-09-2021 |
| | | | EP | 3885778 A1 | 29-09-2021 |
| | | | EP | 4339633 A2 | 20-03-2024 |
| | | | US | 2021293580 A1 | 23-09-2021 |
| | | | US | 2024125624 A1 | 18-04-2024 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3885779 A1
- US 2010237859 A1
- US 2019079142 A1
- EP 4328607 A1